# EUROPEAN PATENT APPLICATION

(11) **EP 4 093 167 A1**
(43) Date of publication of application: **23.11.2022**
(21) Application number: 21741783.1
(22) Date of filing: 14.01.2021
(51) Int. Cl.: H05K 7/20, F28D 1/06, F28F 21/06, F28F 21/08, H01L 23/473, H05K 5/04

(54) **HOUSING, STRUCTURE, AND HOUSING MANUFACTURING METHOD**

(30) Priority: 17.01.2020 JP 2020005853; 17.01.2020 JP 2020005866
(71) Applicant: Mitsui Chemicals, Inc., Tokyo 105-7122 (JP)
(72) Inventor: KIMURA Kazuki, Sodegaura-shi, Chiba 299-0265 (JP); SHIMBORI Nobuyoshi, Sodegaura-shi, Chiba 299-0265 (JP); KURIYAGAWA Mizue, Sodegaura-shi, Chiba 299-0265 (JP)
(74) Representative: J A Kemp LLP
(86) International application number: PCT/JP2021/000979
(87) International publication number: WO 2021/145361

(57) **Abstract**

A cooling type housing (100) for housing a heating element (50) inside, including: an assembled metal housing (10); and a cooling flow path (30) provided at least on one surface (10A) of the metal housing (10), in which a heat medium flows, in which the cooling flow path (30) constitutes at least a part of the one surface (10A) of the metal housing (10).

## Description

### TECHNICAL FIELD

The present invention relates to a housing, a structural body, and a method of manufacturing the housing.

### BACKGROUND ART

In recent years, batteries have been attracting attention as a power source for electric vehicles and the like. It has been known that high-output and high-capacity batteries generate a large quantity of heat during the course of charging or discharging, and the heat causes deterioration of the battery. Therefore, the batteries require a cooling system.

In addition, a countermeasure against heat has been thought to be important for electronic components mounted with a semiconductor element, which is a heat generating element. In particular, the power consumption per electronic component has remarkably increased due to the recent tendency toward the miniaturization and high-density packaging of electronic components, or the speeding up of microprocessors, and an efficient cooling system is important.

In recent years, liquid-cooling type cooling devices have been employed as a cooling system for a heating element such as a battery or an electronic component. A liquid-cooling type cooling device is a device in which a metal plate having a built-in flow path for circulating a refrigerant, a so-called cold plate, is brought into contact with a heating element, and by the refrigerant passing through the flow path, heat generated from the heating element is transferred to a heat sink on the heat dissipation side provided outside the device to cool the heating element (for example, see Patent Document 1).

In addition, as a housing for dissipating heat of an electronic component to the outside, a housing including an assembled metal housing and a heat exchange member bonded to one surface of the metal housing is also known (see Patent Document 2).

### RELATED DOCUMENT

### PATENT DOCUMENT

[Patent Document 1] International Publication No. WO2017/002325
[Patent Document 2] Japanese Unexamined Patent Publication No. 2019-149455

### SUMMARY OF THE INVENTION

### TECHNICAL PROBLEM

The assembled metal housing disclosed in Patent Document 2 has room for improvement in terms of thermal efficiency.

The present invention has been contrived in view of the above circumstances, and provides a housing and a structural body having excellent heat exchange efficiency.

### SOLUTION TO PROBLEM

According to the present invention, the following housing, structural body, and method of manufacturing the housing are provided.
[1] A housing for housing a heating source inside, including:
   an assembled metal housing; and
   a heat exchange member provided at least on one surface of the metal housing, in which a heat medium flows,
   in which the heat exchange member constitutes at least a part of the one surface of the metal housing.
[2] The housing according to [1],
   in which the heating source and the heat exchange member are in direct contact with each other or in contact with each other through a heat conductive member.
[3] The housing according to [1] or [2], further including:
   a resin sealing material,
   in which a gap between adjacent sides of metal plates constituting the metal housing is sealed with the resin sealing material.
[4] The housing according to [3],
   in which tensile elastic modulus of the resin sealing material at 23°C, measured according to ISO527, is 1,000 MPa or more.
[5] The cooling type housing according to any one of [1] to [4], further including:
   a resin member bonded to one surface of the metal housing.
[6] The housing according to [5],
   in which the resin member includes a reinforcing member.
[7] The housing according to [5] or [6],
   in which a metal plate constituting the metal housing has a fine uneven structure at least on a surface of a bonding portion with the resin member, and
   the metal housing and the resin member are bonded by allowing a part of the resin member to enter into the fine uneven structure.
[8] The housing according to [7],
   in which an interval period of the fine uneven structure is in a range of 0.01 µm or more and 500 µm or less.
[9] The housing according to any one of [5] to [8], further including:
   a resin sealing material,
   in which a gap between adjacent sides of metal plates constituting the metal housing is sealed with the resin sealing material, and
   the resin sealing material and the resin member are formed of the same resin.
[10] The housing according to any one of [1] to [9],
   in which an average thickness of metal plates constituting the metal housing is 0.2 mm or more and 10 mm or less.
[11] The housing according to any one of [1] to [10],
   in which the heat exchange member is formed of a plurality of members including the metal housing, and
   the plurality of members are bonded by a resin bonding member.
[12] The housing according to [11],
   in which a metal plate constituting the metal housing has a fine uneven structure at least on a surface of a bonding portion with the resin bonding member, and
   the metal housing and the resin bonding member are bonded by allowing a part of the resin bonding member to enter into the fine uneven structure.
[13] The housing according to [12],
   in which an interval period of the fine uneven structure is in a range of 0.01 µm or more and 500 µm or less.
[14] The housing according to any one of [1] to [13],
   in which a metal plate constituting the metal housing is formed of at least one metal member selected from the group consisting of an aluminum member, an aluminum alloy member, a copper member, and a copper alloy member.
[15] A structural body including: the housing according to any one of [1] to [14]; and
   the heating source housed inside the housing,
   in which the heating source is disposed on a surface of the heat exchange member in the housing.
[16] The structural body according to [15],
   in which the heating source includes at least one selected from the group consisting of a secondary battery module and a power conversion device.
[17] A housing for housing a heating source inside, including:
   an assembled metal housing;
   a heat exchange member provided at least on one surface of the metal housing; and
   a resin sealing material for sealing a gap between adjacent sides of metal plates constituting the metal housing.
[18] The housing according to [17],
   in which tensile elastic modulus of the resin sealing material at 23°C, measured according to ISO527, is 1,000 MPa or more.
[19] The housing according to [17] or [18], further including:
   a resin member bonded to one surface of the metal housing.
[20] The housing according to [19],
   in which the resin member includes a reinforcing member.
[21] The housing according to [19] or [20],
   the resin sealing material and the resin member are formed of the same resin.
[22] The housing according to any one of [19] to [21],
   in which a metal plate constituting the metal housing has a fine uneven structure at least on a surface of a bonding portion with the resin member, and
   the metal housing and the resin member are bonded by allowing a part of the resin member to enter into the fine uneven structure.
[23] The housing according to [22],
   in which an interval period of the fine uneven structure is in a range of 0.01 µm or more and 500 µm or less.
[24] The housing according to any one of [17] to [23],
   in which an average thickness of metal plates constituting the metal housing is 0.2 mm or more and 10 mm or less.
[25] The housing according to any one of [17] to [24],
   in which a metal plate constituting the metal housing is formed of at least one metal member selected from the group consisting of an aluminum member, an aluminum alloy member, a copper member, and a copper alloy member.
[26] The housing according to any one of [17] to [25],
   a heat medium flows inside the heat exchange member.
[27] A structural body including: the housing according to any one of [17] to [26]; and
   the heating source housed inside the cooling type housing.
[28] The structural body according to [27],
   in which the heating source includes at least one selected from the group consisting of a secondary battery module and a power conversion device.
[29] A method of manufacturing the housing according to any one of [1] to [14], including:
   a step of preparing a plurality of metal plates or a development view-like metal plate; and
   a step of producing the metal housing by assembling the plurality of metal plates or the development view-like metal plate.
[30] A method of manufacturing the housing according to any one of [17] to [28], including:
   a step of preparing a plurality of metal plates or a development view-like metal plate;
   a step of producing the metal housing by assembling the plurality of metal plates or the development view-like metal plate; and
   a step of sealing a gap between adjacent sides of metal plates constituting the metal housing with the resin sealing material.

### ADVANTAGEOUS EFFECTS OF INVENTION

According to the present invention, it is possible to provide a housing and a structural body having excellent heat exchange efficiency.

### BRIEF DESCRIPTION OF THE DRAWINGS

Fig. 1 is a cross-sectional view schematically showing an example of the structure of a cooling type housing according a first embodiment.
Fig. 2 is a perspective view schematically showing an example of the structure of an assembled metal housing according to the first embodiment.
Fig. 3 is a perspective view schematically showing an example of the structure of a development view-like metal plate according to the first embodiment.
Fig. 4 is a perspective view schematically showing an example of the structure of the assembled metal housing according to the first embodiment.
Fig. 5 shows cross-sectional views schematically showing an example of the structure of a cooling flow path according to the first embodiment.
Fig. 6 is a cross-sectional view schematically showing an example of the structure of a structural body according to the first embodiment.
Fig. 7 is a schematic view for illustrating measurement positions of a total of six straight line portions consisting of optional three straight line portions having a parallel relationship on a bonding portion surface of the metal plate according to the first embodiment and optional three straight line portions orthogonal to the three straight line portions.
Fig. 8 is a perspective view schematically showing an example of the structure of a cooling type housing according a second embodiment.
Fig. 9 is a cross-sectional view schematically showing an example of the structure of the cooling type housing according the second embodiment.
Fig. 10 is a perspective view schematically showing an example of the structure of a development view-like metal plate according to the second embodiment.
Fig. 11 is a perspective view schematically showing an example of the structure of an assembled metal housing according to the second embodiment.
Fig. 12 is a cross-sectional view schematically showing an example of the structure of a structural body according to the second embodiment.

### DESCRIPTION OF EMBODIMENTS

Hereinafter, embodiments of the present invention will be described using the drawings. In all the drawings, the same constituent elements are denoted by the same reference signs, and description thereof will not be repeated. In addition, the drawings are schematic drawings, and dimension ratios in the drawings are different from the actual dimension ratios. Unless otherwise specified, the expression "to" between numbers in the sentence represents equal to or more than the number and equal to or less than the other number.

In the following embodiments, a housing for housing a heating source inside, including an assembled metal housing and a heat exchange member provided at least on one surface of the metal housing, will be described.

The housing realizes temperature control having a cooling function, a heat retaining function, and a heating function, and a cooling type housing having a cooling function will be described below. The heating source includes a heat source (heating element) which supplies heat to a heat medium and a cold source which supplies cold to the heat medium, and the heating element will be mainly described below. In addition, a cooling flow path in which cooling water flows will be described as an example of the heat exchange member.

### <First Embodiment>

### 1. Cooling Type Housing

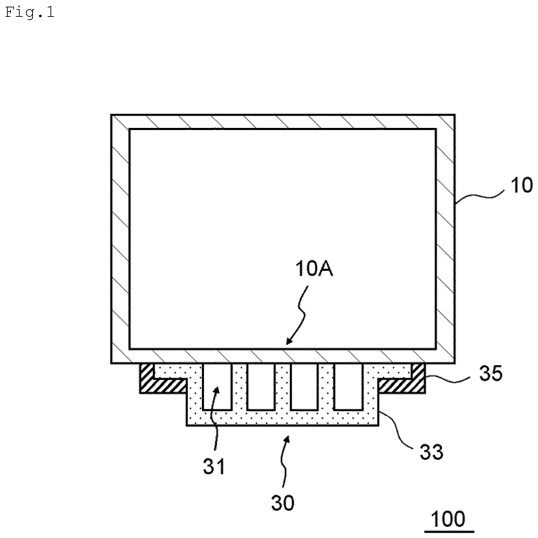

Fig. 1 is a cross-sectional view schematically showing an example of the structure of a cooling type housing 100 according to this embodiment.

The cooling type housing 100 according to this embodiment is a cooling type housing 100 for housing a heating element 50 inside, and includes an assembled metal housing 10, and a cooling flow path 30 provided at least on one surface 10A of the metal housing 10, in which a heat medium flows. The cooling flow path 30 constitutes at least a part of the one surface 10A of the metal housing 10.

In the cooling type housing 100 according to this embodiment, the heating element 50 and the cooling flow path 30 are preferably in direct contact with each other or in contact with each other through a heat conductive member. Accordingly, the cooling efficiency can be further improved.

A heat conductive member for transferring heat may be present between the heating element 50 and the cooling flow path 30.

The heat conductive member is, for example, a heat conductive adhesive or a heat conductive sheet, and examples thereof include a thermal interface material (TIM) and a gap filler. Furthermore, at least a part of the metal housing 10 which is in contact with the heat conductive member preferably has a fine uneven structure. Accordingly, the heat conductive member enters and adheres to the fine uneven structure, and even higher heat conduction efficiency can be exhibited.

In the cooling type housing 100 according to this embodiment, the one surface 10A of the metal housing 10 is directly cooled by a heat medium (for example, cooling medium) made conductive to a space portion 31 formed in the cooling flow path 30. Accordingly, the cooling efficiency of the heating element 50 which is in contact with the one surface 10A of the metal housing 10 can be increased.

Therefore, according to this embodiment, it is possible to provide a cooling type housing 100 having excellent cooling efficiency.

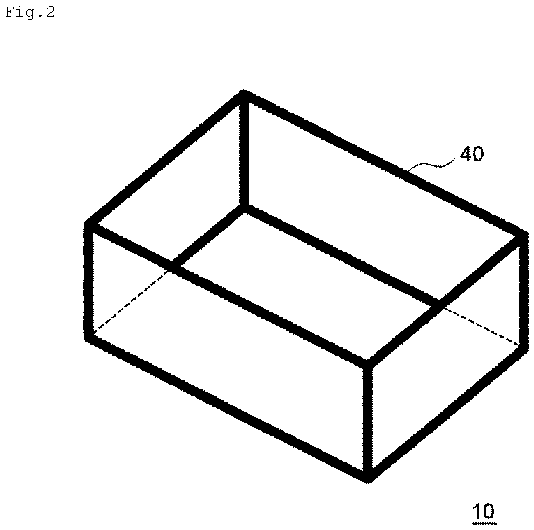

Fig. 2 is a perspective view schematically showing an example of the structure of the assembled metal housing 10 according to this embodiment.

As shown in Fig. 2, the cooling type housing 100 according to this embodiment preferably further includes a resin sealing material 40 for sealing a gap between adjacent sides of metal plates constituting the metal housing 10. Accordingly, the airtightness inside the cooling type housing 100 can be increased, and as a result, the cooling type housing can be preferably used for heating elements which are sensitive to moisture, such as secondary battery modules and power conversion devices (inverters, converters, and the like).

The resin composition constituting the resin sealing material 40 will be described in the section of resin member to be described later.

The tensile elastic modulus of the resin sealing material 40 at 23°C, measured according to ISO527, is preferably 1,000 MPa or more from the viewpoint of increasing the box rigidity of the metal housing 10. The upper limit of the tensile elastic modulus of the resin sealing material 40 at 23°C is not particularly limited, and is, for example, 500 GPa or less.

### <Assembled Metal Housing>

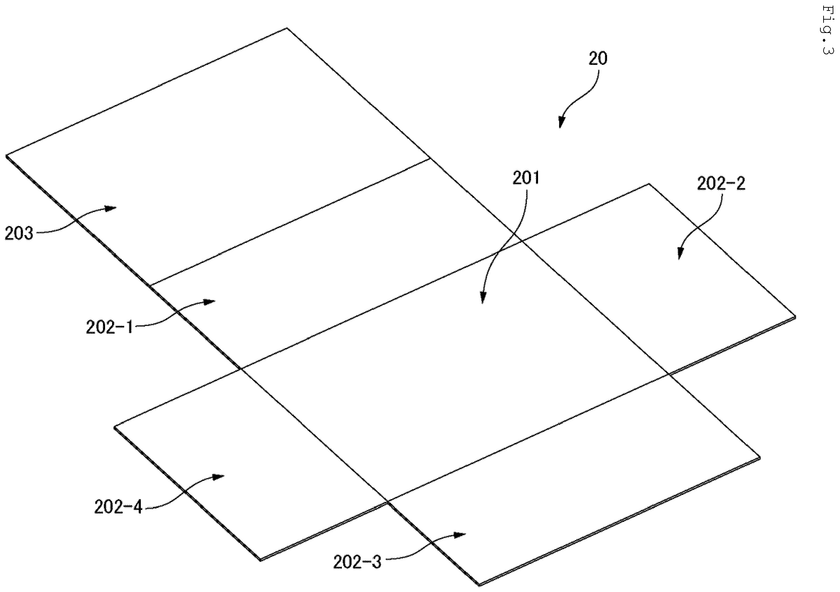

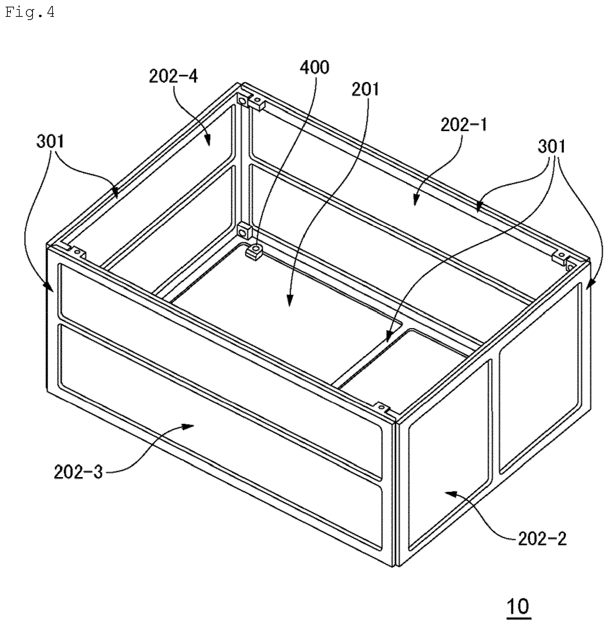

Fig. 3 is a perspective view schematically showing an example of the structure of a development view-like metal plate 20 according to this embodiment. Fig. 4 is a perspective view schematically showing an example of the structure of the assembled metal housing 10 according to this embodiment.

The assembled metal housing 10 according to this embodiment can be formed by, for example, assembling a plurality of metal plates or the development view-like metal plate 20 (hereinafter, these will also be collectively referred to as the metal plate).

That is, the cooling type housing 100 can be obtained by, for example, a manufacturing method including a step of preparing a plurality of metal plates or a development view-like metal plate 20 and a step of assembling the plurality of metal plates or the development view-like metal plate 20 to produce the metal housing 10.

### (Metal Plate)

The assembled metal housing 10 according to this embodiment can be formed, by, for example, assembling a plurality of metal plates or a development view-like metal plate 20.

The development view-like metal plate 20 according to this embodiment includes, for example, a metal bottom plate 201 and/or a metal lid plate 203, and a metal side plate 202 (at least one metal plate selected from a side plate 202-1, a side plate 202-2, a side plate 202-3, and a side plate 202-4) which is integrally folded and connected to the bottom plate and/or the lid plate.

A first preferable aspect includes a bottom plate 201, a side plate 202-1, a side plate 202-2, a side plate 202-3, and a side plate 202-4. A second preferable aspect includes a bottom plate 201, a side plate (front plate) 202-1, side plates (both side plates) 202-2 and 202-4, and a lid plate 203. A third preferable aspect includes a bottom plate 201, a side plate 202-1, a side plate 202-2, a side plate 202-3, a side plate 202-4, and a lid plate 203. Among these aspects, the first and second aspects are particularly preferable.

Here, the plates can be engaged with each other by a mechanical engaging method. In particular, the side plates 202 are preferably engaged with each other by a mechanical method. The mechanical engaging method (also referred to as the physical engaging method) is not particularly limited, and examples thereof include screwing.

In addition, the side plate 202 and the bottom plate 201, and/or the lid plate 203 may be engaged with each other by the above-described mechanical method, or may be integrally folded and connected to one optional side plate.

Furthermore, in the cooling type housing 100 according to this embodiment, since the metal bottom plate 201 and/or the lid plate 203, and the metal side plate 202 are integrally connected, no component is required to connect the bottom plate and the side plate, and the number of components can be reduced. As a result, process management can be simplified. In addition, the number of grounding setting portions can also be reduced. In the cooling type housing 100 according to this embodiment, since the number of components and the number of grounding setting portions can be reduced, it is possible to realize a lighter cooling type housing 100.

The metal housing 10 has two roles of diffusing the heat from the heating element 50 and efficiently transferring the heat to the heat medium flowing in the cooling flow path 30. Therefore, the material of the metal plate constituting the metal housing 10 preferably has excellent heat conductivity. From such a viewpoint, an aluminum-based metal or a copper-based metal is used as the metal species constituting the metal plate, and specifically, the metal plate is preferably formed of at least one metal member selected from the group consisting of an aluminum member, an aluminum alloy member, a copper member, and a copper alloy member.

The thickness of the metal plate constituting the metal housing 10 may be the same in all places or may vary depending on the place. The average thickness of the metal plates constituting the metal housing 10 is, for example, 0.2 mm or more and 10 mm or less, preferably 0.2 mm or more and 5.0 mm or less, more preferably 0.2 mm or more and 2.0 mm or less, even more preferably 0.2 mm or more and 1.0 mm or less, and particularly preferably 0.2 mm or more and 0.8 mm or less in comprehensive consideration of heat conductivity, strength, and lightweight property.

In a case where the average thickness of the metal plates is equal to or more than the lower limit, the mechanical strength, heat dissipation characteristics, and electromagnetic wave shielding characteristics of the cooling type housing 100 to be obtained can be improved.

In a case where the average thickness of the metal plates is equal to or less than the upper limit, the cooling type housing 100 to be obtained can be made lighter. Furthermore, in a case where the average thickness of the metal plates is equal to or less than the upper limit, it becomes easier to fold the metal plate, and the productivity of the cooling type housing 100 can be further improved.

The metal housing 10 according to this embodiment preferably has a fine uneven structure at least on a bonding portion surface of the metal plate bonded to the resin member (including the resin sealing material 40 and a resin bonding member 35 to be described later) . In this case, since a part of the resin member enters into the fine uneven structure and the metal plate constituting the metal housing 10 and the resin member are thus bonded, physical resistance power (anchor effect) is effectively exhibited between the metal plate and the resin member, and the bonding strength between the metal housing 10 and the resin member can be improved. Accordingly, since the mechanical strength of the cooling type housing 100 can be improved, the thickness of the metal housing 10 constituting the cooling type housing 100 can be further reduced. As a result, it is possible to obtain a lighter cooling type housing 100.

The fine uneven structure on the surface of the metal plate is preferably a fine uneven structure in which projecting portions stand close together with an interval period of 0.01 µm or more and 500 µm or less from the viewpoint of further firmly strengthening the bonding between the metal plate and the resin member.

Here, the interval period of the fine uneven structure is an average of distances from projecting portions to adjacent projecting portions, and can be obtained using a photograph taken by an electron microscope or a laser microscope, or a surface roughness measuring device.

The interval period measured by an electron microscope or a laser microscope is usually less than 0.5 µm, and specifically, the surface of the bonding portion between the metal plate and the resin member is photographed. From the photograph, 50 projecting portions are optionally selected, and each of distances from the projecting portions to adjacent projecting portions is measured. The sum of all the distances from the projecting portions to adjacent projecting portions is divided by 50, and the resulting value is defined as the interval period. An interval period of 0.5 µm or more is usually obtained using a surface roughness measuring device.

Usually, the surface roughening treatment is performed not only on the bonding portion surface of the metal plate but also on the entire surface of the metal plate, so that it is also possible to measure the interval period from a place other than the bonding portion surface in the same plane as the bonding portion surface of the metal plate.

The interval period of the fine uneven structure is preferably 0.02 µm or more and 100 µm or less, more preferably 0.05 µm or more and 50 µm or less, even more preferably 0.05 µm or more and 20 µm or less, and particularly preferably 0.10 µm or more and 10 µm or less.

In a case where the interval period of the fine uneven structure is equal to or more than the lower limit, the resin member can be more deeply advanced into the recessed portions of the fine uneven structure, and the bonding strength between the metal plate and the resin member can be further improved.

In addition, in a case where the interval period is equal to or less than the upper limit, it is possible to suppress the formation of a gap at the bonding portion between the metal plate and the resin member. As a result, since it is possible to suppress the entering of impurities such as moisture from the gap at the metal-resin interface, it is possible to suppress a reduction in strength in a case where the cooling type housing 100 is used at a high temperature and a high humidity. Furthermore, it is possible to suppress the leakage of the heat medium from the bonding portion between the metal plate and the resin bonding member 35 to be described later.

The method of forming the fine uneven structure on the surface of the metal plate is not particularly limited, and examples thereof include a method of immersing the metal plate in an aqueous solution of an inorganic base such as sodium hydroxide and/or an aqueous solution of an inorganic acid such as hydrochloric acid or nitric acid; a method of treating the metal plate by an anodizing method; a method of forming a fine uneven structure on the surface of the metal plate by pressing a die punch having a fine uneven structure produced by mechanical cutting such as diamond abrasive grain grinding or blasting against the surface of the metal plate; a method of forming a fine uneven structure on the surface of the metal plate by sand blasting, knurling, or laser processing; and a method of immersing the metal plate in an aqueous solution of one or more selected from hydrated hydrazine, ammonia, and a water-soluble amine compound as disclosed in International Publication No. WO2009/31632.

Especially in a case where the immersion method is employed among the above methods, the fine uneven structure is formed not only on the bonding surface of the metal plate with the resin member, but also on the entire surface of the metal plate. However, such an embodiment does not impair the effects of the present invention at all, but rather increases a heat exchange area with the heat medium and can realize better cooling efficiency. Moreover, the thermal emissivity of the metal plate may be increased, and the heat dissipation property of the housing may be improved.

In addition, from the viewpoint of further improving the bonding strength between the metal plate and the resin member, regarding a total of six straight line portions consisting of optional three straight line portions having a parallel relationship on the bonding portion surface of the metal plate and optional three straight line portions orthogonal to the three straight line portions, the surface roughness measured according to JIS B0601 (corresponding international standard: ISO4287) preferably simultaneously satisfies the following requirements (1) and (2).
(1) One or more straight line portions whose load length ratio (Rmr) of a roughness curve in a case where the cutting level is 20% and the evaluation length is 4 mm is 30% or less are included.
(2) Ten-point average roughness (Rz) of all of the straight line portions in a case where the evaluation length is 4 mm is more than 2 µm.

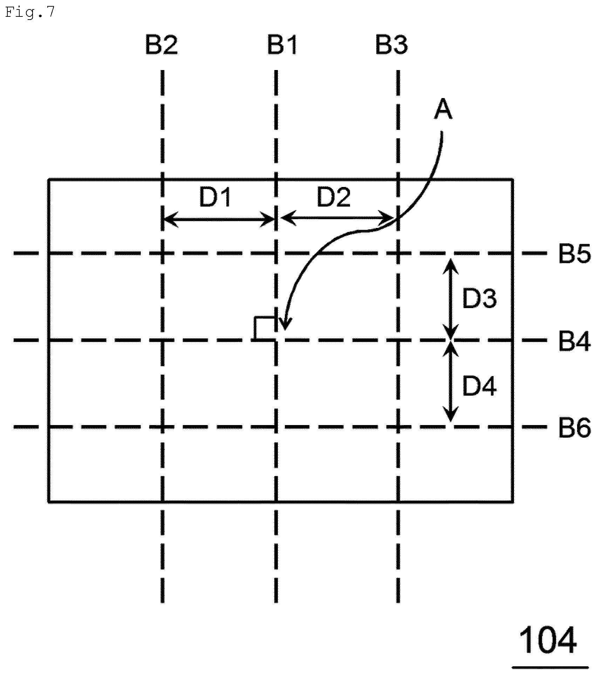

Fig. 7 is a schematic view for illustrating the total of six straight line portions consisting of optional three straight line portions having a parallel relationship on a bonding portion surface 104 of the metal plate and optional three straight line portions orthogonal to the three straight line portions.

As the six straight line portions, for example, six straight line portions B1 to B6 can be selected as shown in Fig. 7. First, a central line B1 passing through a central portion A of the bonding portion surface 104 of the metal plate is selected as a reference line. Next, straight lines B2 and B3 parallel to the central line B1 are selected. Next, a central line B4 orthogonal to the central line B1 is selected, and straight lines B5 and B6 orthogonal to the central line B1 and parallel to the central line B4 are selected. Here, vertical distances D1 to D4 between the straight lines are, for example, 2 to 5 mm.

Usually, since the surface roughening treatment is performed not only on the bonding portion surface 104 of the metal plate bonded to the resin member, but also on the entire metal plate, the six straight line portions may be selected from a place other than the bonding portion surface 104 in the same plane as or in a plane opposite to the bonding portion surface 104 of the metal plate bonded to the resin member.

It is not necessarily clear why it is possible to obtain a cooling type housing 100 having more excellent bonding strength between the metal plate and the resin member in a case where the requirements (1) and (2) are simultaneously satisfied, and the reason is thought to be that the bonding portion surface 104 of the metal plate bonded to the resin member has such a structure that an anchor effect can be effectively exhibited between the metal plate and the resin member.

From the viewpoint of further improving the bonding strength between the metal plate and the resin member, regarding a total of six straight line portions consisting of optional three straight line portions having a parallel relationship on the bonding portion surface 104 of the metal plate and optional three straight line portions orthogonal to the three straight line portions, the surface roughness measured according to JIS B0601 (corresponding international standard: ISO4287) preferably further satisfies one or more of the following requirements (1A) to (1C), and particularly preferably satisfies the requirement (1C).

(1A) Preferably two or more, more preferably three or more, and even more preferably six straight line portions whose load length ratio (Rmr) of a roughness curve in a case where the cutting level is 20% and the evaluation length is 4 mm is 30% or less are included.

(1B) Preferably one or more, more preferably two or more, even more preferably three or more, and most preferably six straight line portions whose load length ratio (Rmr) of a roughness curve in a case where the cutting level is 20% and the evaluation length is 4 mm is 20% or less are included.

(1C) Preferably one or more, more preferably two or more, even more preferably three or more, and most preferably six straight line portions whose load length ratio (Rmr) of a roughness curve in a case where the cutting level is 40% and the evaluation length is 4 mm is 60% or less are included.

In addition, from the viewpoint of further improving the bonding strength between the metal plate and the resin member, an average of the load length ratios (Rmr) of roughness curves on the bonding portion surface 104 of the metal plate, measured according to JIS B0601 (corresponding international standard: ISO4287), in a case where the cutting level is 20% and the evaluation length is 4 mm is preferably 0.1% or more and 40% or less, more preferably 0.5% or more and 30% or less, even more preferably 1% or more and 20% or less, and most preferably 2% or more and 15% or less.

As the average of the load length ratios (Rmr), a value obtained by averaging the load length ratios (Rmr) of the optional six straight line portions described above can be employed.

The load length ratio (Rmr) of the bonding portion surface 104 of the metal plate according to this embodiment can be controlled by appropriately adjusting the conditions of the roughening treatment for the surface of the metal plate.

In this embodiment, in particular, examples of the factor for controlling the load length ratio (Rmr) include the type and concentration of an etching agent, the temperature and time of the roughening treatment, and the timing of the etching treatment.

From the viewpoint of further improving the bonding strength between the metal plate and the resin member, regarding a total of six straight line portions consisting of optional three straight line portions having a parallel relationship on the bonding portion surface 104 of the metal plate and optional three straight line portions orthogonal to the three straight line portions, the surface roughness measured according to JIS B0601 (corresponding international standard: ISO4287) preferably further satisfies the following requirement (2A).

(2A) Ten-point average roughness (Rz) of all of the straight line portions in a case where the evaluation length is 4 mm are preferably more than 5 µm, more preferably 10 µm or more, and even more preferably 15 µm or more.

From the viewpoint of further improving the bonding strength between the metal plate and the resin member, an average of the ten-point average roughness (Rz) on the bonding portion surface 104 of the metal plate is preferably more than 2 µm and 50 µm or less, more preferably more than 5 µm and 45 µm or less, even more preferably 10 µm or more and 40 µm or less, and particularly preferably 15 µm or more and 30 µm or less.

As the average of the ten-point average roughness (Rz), a value obtained by averaging the ten-point average roughness (Rz) of the optional six straight line portions described above can be employed.

From the viewpoint of further improving the bonding strength between the metal plate and the resin member, regarding a total of six straight line portions consisting of optional three straight line portions having a parallel relationship on the bonding portion surface 104 of the metal plate and optional three straight line portions orthogonal to the three straight line portions, the surface roughness measured according to JIS B0601 (corresponding international standard: ISO4287) preferably further satisfies the following requirement (4).

(4) An average length (RSm) of roughness curve elements of all of the straight line portions is more than 10 µm and less than 300 µm, and more preferably 20 µm or more and 200 µm or less.

From the viewpoint of further improving the bonding strength between the metal plate and the resin member, an average of the average lengths (RSm) of roughness curve elements on the bonding portion surface 104 of the metal plate is preferably more than 10 µm and less than 300 µm, and more preferably 20 µm or more and 200 µm or less.

As the average of the average lengths (RSm) of roughness curve elements, a value obtained by averaging the ten-point average roughness (Rz) of the optional six straight line portions described above can be employed.

Here, in this embodiment, in a case where the average thickness of the metal plates is in a range of 500 µm or more, the average of the average lengths (RSm) of roughness curve elements is the interval period.

The ten-point average roughness (Rz) of the bonding portion surface 104 of the metal plate according to this embodiment and the average length (RSm) of the roughness curve elements can be controlled by appropriately adjusting the conditions of the roughening treatment for the surface of the metal member.

In this embodiment, in particular, examples of the factor for controlling the ten-point average roughness (Rz) and the average length (RSm) of the roughness curve elements include the temperature and time of the roughening treatment, and the etching amount.

### (Surface Treatment)

Next, a method of preparing the metal plate satisfying the above-described interval period, load length ratio (Rmr), ten-point average roughness (Rz), average length (RSm) of roughness curve elements, and the like will be described.

Such a metal plate can be formed by, for example, performing the roughening treatment on the surface of the metal member by using an etching agent.

Hereinafter, an example of a metal plate roughening treatment method for obtaining a metal plate satisfying the above-described interval period, load length ratio (Rmr), ten-point average roughness (Rz), average length (RSm) of roughness curve elements, and the like will be shown. However, the metal plate roughening treatment method according to this embodiment is not limited to the following example.

### (1) Pre-treatment Step

First, it is desirable that the metal plate has no thick film formed of an oxide film or a hydroxide on the surface on the bonding side to the resin member. In order to remove such a thick film, the surface layer may be polished by mechanical polishing such as sand blasting, shot blasting, grinding, or barreling, or chemical polishing before the next step of performing a treatment with an etching agent. In addition, in a case where the surface on the bonding side to the resin member is significantly contaminated by machine oil or the like, a treatment using an alkaline aqueous solution such as an aqueous solution of sodium hydroxide or an aqueous solution of potassium hydroxide, or degreasing is preferably performed.

### (2) Surface Roughening Treatment Step

In this embodiment, as the surface roughening treatment method for the metal plate, a treatment using an acid-based etching agent to be described later is preferably performed at a specific timing. Specifically, the treatment using an acid-based etching agent is preferably performed at the final stage of the surface roughening treatment step.

Examples of the roughening treatment method using the acid-based etching agent include a treatment method by immersion, spraying, or the like. The treatment temperature is preferably 20°C to 40°C, and the treatment time is preferably about 5 to 350 seconds. From the viewpoint that the surface of the metal member can be more uniformly roughened, the treatment time is more preferably 20 to 300 seconds, and particularly preferably 50 to 300 seconds.

By the roughening treatment using the acid-based etching agent, the surface of the metal plate is roughened into an uneven shape. The etching amount (dissolution amount) of the metal plate in a depth direction in using the acid-based etching agent is preferably 0.1 to 500 µm, more preferably 5 to 500 µm, and even more preferably 5 to 100 µm in a case where it is calculated from the mass, specific gravity, and surface area of the melted metal plate. In a case where the etching amount is equal to or more than the lower limit, the bonding strength between the metal plate and the resin member can be further improved. In addition, in a case where the etching amount is equal to or less than the upper limit, the treatment cost can be reduced. The etching amount can be adjusted by the treatment temperature, treatment time, and the like.

In this embodiment, in a case where the roughening treatment is performed on the metal plate using the acid-based etching agent, the entire surface of the metal portion plate may be roughened, or only the surface to which the resin member is bonded may be partially roughened.

### (3) Post-treatment Step

In this embodiment, usually, water washing and drying are preferably performed after the surface roughening treatment step. The water washing method is not particularly limited, and washing is preferably performed for a predetermined time by immersion or running water.

Furthermore, as the post-treatment step, ultrasonic washing is preferably performed to remove smut and the like generated by the treatment using the acid-based etching agent. The conditions of the ultrasonic washing are not particularly limited as long as it is possible to remove the generated smut and the like. Water is preferable as a solvent to be used, and the treatment time is preferably 1 to 20 minutes.

### (Acid-based Etching Agent)

In this embodiment, as the etching agent to be used for the roughening treatment for the surface of the metal plate, a specific acid-based etching agent to be described later is preferable. It is thought that by performing the treatment with the specific etching agent, a fine uneven structure suitable for improving the adhesion between the metal plate and the resin member is formed on the surface of the metal plate, and due to the anchor effect, the bonding strength between the metal plate and the resin member is further improved.

Hereinafter, components of the acid-based etching agent which can be used in this embodiment will be described.

The acid-based etching agent contains at least one of a ferric ion and a cupric ion, and an acid, and may optionally contain a manganese ion, various additives, and the like.

### • Ferric Ion

The ferric ion is a component which oxidizes a metal member. By blending a ferric ion source, the ferric ion can be contained in the acid-based etching agent. Examples of the ferric ion source include ferric nitrate, ferric sulfate, and ferric chloride. Among the ferric ion sources, ferric chloride is preferable since it has excellent solubility and is inexpensive.

In this embodiment, the content of the ferric ion in the acid-based etching agent is preferably 0.01 to 20 mass%, more preferably 0.1 to 12 mass%, even more preferably 0.5 to 7 mass%, still more preferably 1 to 6 mass%, and particularly preferably 1 to 5 mass% . In a case where the content of the ferric ion is equal to or more than the lower limit, it is possible to prevent a reduction in roughening rate (dissolution rate) of the metal plate. In a case where the content of the ferric ion is equal to or less than the upper limit, the roughening rate can be appropriately maintained, and thus uniform roughening more suitable for improving the bonding strength between the metal plate and the resin member can be performed.

### • Cupric Ion

The cupric ion is a component which oxidizes a metal member. By blending a cupric ion source, the cupric ion can be contained in the acid-based etching agent. Examples of the cupric ion source include cupric sulfate, cupric chloride, cupric nitrate, and cupric hydroxide. Among the cupric ion sources, cupric sulfate and cupric chloride are preferable since these are inexpensive.

In this embodiment, the content of the cupric ion in the acid-based etching agent is preferably 0.001 to 10 mass%, more preferably 0.01 to 7 mass%, even more preferably 0.05 to 1 mass%, still more preferably 0.1 to 0.8 mass%, yet still more preferably 0.15 to 0.7 mass%, and particularly preferably 0.15 to 0.4 mass%. In a case where the content of the cupric ion is equal to or more than the lower limit, it is possible to prevent a reduction in roughening rate (dissolution rate) of the metal plate. In a case where the content of the cupric ion is equal to or less than the upper limit, the roughening rate can be appropriately maintained, and thus uniform roughening more suitable for improving the bonding strength between the metal plate and the resin member can be performed.

The acid-based etching agent may contain only one or both of a ferric ion and a cupric ion, and both a ferric ion and a cupric ion are preferably contained. In a case where the acid-based etching agent contains both a ferric ion and a cupric ion, a good roughened shape more suitable for improving the bonding strength between the metal plate and the resin member is easily obtained.

In a case where the acid-based etching agent contains both a ferric ion and a cupric ion, the content of each of the ferric ion and the cupric ion is preferably in the above range. The total content of the ferric ion and the cupric ion in the acid-based etching agent is preferably 0.011 to 20 mass%, more preferably 0.1 to 15 mass%, even more preferably 0.5 to 10 mass%, and particularly preferably 1 to 5 mass%.

### • Manganese Ion

The acid-based etching agent may contain a manganese ion to evenly and uniformly roughen the surface of the metal plate. By blending a manganese ion source, the manganese ion can be contained in the acid-based etching agent. Examples of the manganese ion source include manganese sulfate, manganese chloride, manganese acetate, manganese fluoride, and manganese nitrate. Among the manganese ion sources, manganese sulfate and manganese chloride are preferable since these are inexpensive.

In this embodiment, the content of the manganese ion in the acid-based etching agent is preferably 0 to 1 mass%, and more preferably 0 to 0.5 mass%.

### • Acid

The acid is a component which dissolves a metal oxidized by the ferric ion and/or the cupric ion. Examples of the acid include inorganic acids such as a hydrochloric acid, a hydrobromic acid, a sulfuric acid, a nitric acid, a phosphoric acid, a perchloric acid, and a sulfamic acid, and organic acids such as a sulfonic acid and a carboxylic acid. Examples of the carboxylic acid include a formic acid, an acetic acid, a citric acid, an oxalic acid, and a malic acid. One or two or more of the acids can be blended in the acid-based etching agent. Among the inorganic acids, a sulfuric acid is preferable since it has little odor and is inexpensive. In addition, among the organic acids, a carboxylic acid is preferable from the viewpoint of uniformity of the roughened shape.

In this embodiment, the content of the acid in the acid-based etching agent is preferably 0.1 to 50 mass%, more preferably 0.5 to 50 mass%, even more preferably 1 to 50 mass%, still more preferably 1 to 30 mass%, yet still more preferably 1 to 25 mass%, and still more preferably 2 to 18 mass%. In a case where the content of the acid is equal to or more than the lower limit, it is possible to prevent a reduction in roughening rate (dissolution rate) of the metal plate. In a case where the content of the acid is equal to or less than the upper limit, it is possible to prevent crystal precipitation of the metal salt of the metal plate in a case where the liquid temperature is reduced, so that workability can be improved.

### • Other Components

To the acid-based etching agent which can be used in this embodiment, a surfactant may be added to prevent uneven roughening due to surface contaminants such as fingerprints, or other additives may be optionally added. Examples of other additives include a halide ion source which is added to form deep unevenness, such as sodium chloride, potassium chloride, sodium bromide, and potassium bromide. A thio compound such as a thiosulfate ion and thiourea, which is added to increase the roughening treatment rate, azoles such as imidazole, triazole, and tetrazole, which are added to obtain a more uniform roughened shape, a pH adjuster which is added to control the roughening reaction, and the like can also be included. In a case where these other components are added, the total content thereof is preferably about 0.01 to 10 mass% in the acid-based etching agent.

The acid-based etching agent of this embodiment can be easily prepared by dissolving the above-described components in ion-exchanged water or the like.

### (Resin Member)

In the assembled metal housing 10 according to this embodiment, a resin member may be further bonded to one surface of the metal housing. Examples of the resin member include, but are not limited to, a reinforcing member 301, a boss 400, a connector, a bracket, and an insulating component. In addition, a part of the resin member may be made of a material other than a resin, and specific examples of the material include a metal, ceramic, glass, and a carbon material.

It is preferable that the reinforcing member 301 is bonded to a part of the surface of the metal plate constituting the metal housing 10, and preferably directly bonded, and the metal plate is reinforced by the reinforcing member 301. In this embodiment, the direct bonding means bonding in which no interposition layer such as an adhesive-containing layer is present between the metal plate and the reinforcing member 301.

In addition, by providing the cooling type housing 100 according to this embodiment with the metal plate, it is possible to obtain an electromagnetic wave shielding function equivalent to that of a housing according to the related art in which the entire housing is formed of metal members.

In a case where the cooling type housing 100 according to this embodiment further includes the reinforcing member 301 on one surface of the metal housing 10, a part thereof is replaced with a lightweight resin member from a heavy metal member, so that the entire housing can be made lighter than a housing according to the related art in which the entire housing is formed of metal members.

Furthermore, in the cooling type housing 100 according to this embodiment, by reinforcing the metal plate with the reinforcing member 301, it is possible to suppress a reduction in mechanical strength of the cooling type housing 100 due to the thickness reduction of the metal plate. That is, it is possible to maintain the mechanical strength while realizing the weight reduction of the cooling type housing 100.

Furthermore, since the reinforcing member 301 is formed only on a part of the surface of the metal plate, it is possible to suppress the covering of the entire surface of the metal plate by the reinforcing member 301, and good heat dissipation characteristics of the metal housing 10 can be maintained.

In the cooling type housing 100 according to this embodiment, the reinforcing member 301 is preferably bonded to both sides of the metal plate. Therefore, since the metal plate can be reinforced from both sides of the metal plate, the mechanical strength of the cooling type housing 100 can be further improved. Accordingly, the thickness of the metal plate can be further reduced, and a cooling type housing 100 which is even lighter can be obtained.

In addition, in a case where the reinforcing member 301 is bonded to both sides of the metal plate, at least a part of the reinforcing member 301 bonded to one side of the metal plate is preferably disposed at the same position so as to face the reinforcing member 301 bonded to the other side in a vertical direction of the plate plane of the metal plate. Therefore, it is possible to suppress the deformation of the metal plate due to the shrinkage of the reinforcing member 301 during molding. In this case, in a plan view, at least a part of the reinforcing member 301 bonded to one side may not overlap with the reinforcing member 301 bonded to the other side.

In the cooling type housing 100 according to this embodiment, the surface area of the bonding portion of the reinforcing member 301 (hereinafter, may be abbreviated as the bonding portion area ratio) in the total surface area of the metal housing 10 is, for example, 1 area% or more and 50 area% or less, preferably 2 area% or more and 40 area% or less, and more preferably 5 area% or more and 30 area% or less. In a case where the bonding portion area ratio is equal to or more than the lower limit, the mechanical strength of the cooling type housing 100 can be improved. In a case where the bonding portion area ratio is equal to or less than the upper limit, it is possible to obtain a lightweight cooling type housing 100 having more excellent heat dissipation characteristics.

In the cooling type housing 100 according to this embodiment, as shown in Fig. 4, the reinforcing member 301 is preferably bonded to at least a peripheral edge portion of the surface of the metal plate constituting the metal housing 10. Therefore, the metal housing 10 can be more effectively reinforced by a smaller amount of the reinforcing member 301. Furthermore, since the amount of the reinforcing member 301 to be used can be reduced, it is possible to suppress the deformation of the metal plate due to the shrinkage of the reinforcing member 301 during molding.

In addition, in the cooling type housing 100 according to this embodiment, as shown in Fig. 4, at least a part of the reinforcing member 301 is preferably formed into, for example, a frame shape on the surface of the metal plate constituting the metal housing 10. For example, the reinforcing member 301 may have a first part extending in a first direction and a second part extending in a second direction different from the first direction. For example, the first part and the second part may extend along the diagonal line of one surface of the metal housing 10, or have a part extending radially around a certain point in one surface of the metal housing 10. In addition, the reinforcing member 301 may have a part extending in a grid shape. Furthermore, the reinforcing member 301 may have a part extending in a spider's web shape.

In any example, in a case where the reinforcing member 301 is formed by injection molding, any part of the reinforcing member 301 is preferably connected to the reinforcing member 301 positioned at the edge of the metal housing 10. Therefore, the whole reinforcing member 301 can be formed by single injection molding.

Examples of the frame shape include at least one shape selected from a brace shape, a grid shape, a truss shape, and a ramen shape. It is preferable that the reinforcing member 301 is formed in a frame shape on the surface of the metal plate since the metal housing 10 can be more effectively reinforced by a smaller amount of the reinforcing member 301.

Furthermore, by forming the reinforcing member 301 in a frame shape on the surface of the metal plate, the amount of the reinforcing member 301 to be used can be reduced, and thus it is possible to suppress the deformation of the metal plate due to the shrinkage of the reinforcing member 301 during molding, and a reduction in heat dissipation characteristics of the cooling type housing 100 due to the reinforcing member 301.

The thickness of the reinforcing member 301 according to this embodiment may be the same in all places or may vary depending on the place.

In the cooling type housing 100 according to this embodiment, the average thickness of the reinforcing members 301 bonded to the surfaces of the metal plates depends on the average thickness of the metal plates and the size of the entire housing, and is, for example, 1.0 mm to 10 mm, preferably 1.5 mm to 8 mm, and more preferably 1.5 mm to 5.0 mm.

In a case where the average thickness of the reinforcing members 301 is equal to or more than the lower limit, the mechanical strength of the cooling type housing 100 to be obtained can be improved.

In a case where the average thickness of the reinforcing members 301 is equal to or less than the upper limit, the cooling type housing 100 to be obtained can be made lighter. In addition, since the amount of the reinforcing member 301 to be used can be reduced, it is possible to suppress the deformation of the metal plate due to the shrinkage of the reinforcing member 301 during molding.

In the cooling type housing 100 according to this embodiment, it is preferable that as shown in Fig. 4, the reinforcing member 301 is bonded to at least a peripheral edge portion, and preferably the whole periphery of the surface of the metal plate. Therefore, the metal housing 10 can be more effectively reinforced by a smaller amount of the reinforcing member 301.

In the metal housing 10 according to this embodiment, it is preferable that the reinforcing member 301 is not bonded to a boundary portion between the bottom plate 201 and/or the lid plate 203 and the side plate 202 (that is, a side of the metal housing 10 (three-dimensional)). Therefore, it becomes easier to fold the boundary portion between the bottom plate 201 and/or the lid plate 203 and the side plate 202, and the metal housing 10 can be more easily obtained.

In the metal housing 10 according to this embodiment, the reinforcing member 301 is preferably bonded to the surface of the metal bottom plate 201 and/or the lid plate 203 and the surface of each of all the metal side plates 202 (in the example shown in Fig. 4, 202-1, 202-2, 202-3, and 202-4). Therefore, the mechanical strength of the cooling type housing 100 can be improved, and the thickness of the metal plate can be further reduced. As a result, it is possible to obtain a lighter cooling type housing 100.

The resin member (including the resin sealing material 40) according to this embodiment is formed of a resin composition (P) . The resin composition (P) contains the resin (P1) as an essential component, and optionally contains other blending agents (P2). For convenience, even in a case where the resin member is formed only of the resin (P1), the resin member is described to be formed of the resin composition (P).

The resin (P1) is not particularly limited, and examples thereof include a thermoplastic resin and a thermosetting resin. Examples of the thermoplastic resin include polyolefin-based resins, (meth)acrylic resins such as a polymethyl (meth)acrylate resin, polystyrene resins, polyvinyl alcohol-polyvinyl chloride copolymer resins, polyvinyl acetal resins, polyvinyl butyral resins, polyvinyl formal resins, polymethylpentene resins, maleic anhydride-styrene copolymer resins, polycarbonate resins, polyphenylene ether resins, aromatic polyether ketones such as polyether ether ketone resins and polyether ketone resins, polyester-based resins, polyamide-based resins, polyamide imide resins, polyimide resins, polyether imide resins, styrene-based elastomers, polyolefin-based elastomers, polyurethane-based elastomers, polyester-based elastomers, polyamide-based elastomers, ionomers, amino polyacrylamide resins, isobutylene-maleic anhydride copolymers, ABS, ACS, AES, AS, ASA, MBS, ethylene-vinyl chloride copolymers, ethylene-vinyl acetate copolymers, ethylene-vinyl acetate-vinyl chloride graft polymers, ethylene-vinyl alcohol copolymers, chlorinated polyvinyl chloride resins, chlorinated polyethylene resins, chlorinated polypropylene resins, carboxyvinyl polymers, ketone resins, amorphous copolyester resins, norbornene resins, fluoroplastics, polytetrafluoroethylene resins, fluorinated ethylene polypropylene resins, PFA, polychlorofluoroethylene resins, ethylene-tetrafluoroethylene copolymers, polyvinylidene fluoride resins, polyvinyl fluoride resins, polyarylate resins, thermoplastic polyimide resins, polyvinylidene chloride resins, polyvinyl chloride resins, polyvinyl acetate resins, polysulfone resins, poly-para-methylstyrene resins, polyallylamine resins, polyvinyl ether resins, polyphenylene oxide resins, polyphenylene sulfide (PPS) resins, polymethylpentene resins, oligoester acrylates, xylene resins, maleic acid resins, polyhydroxybutyrate resins, polysulfone resins, polylactic acid resins, polyglutamic acid resins, polycaprolactone resins, polyether sulfone resins, polyacrylonitrile resins, styrene-acrylonitrile copolymer resins, acrylonitrile-butadiene-styrene copolymer resins, and polyacetal resins. The thermoplastic resins may be used alone or in combination of two or more types thereof.

Among these, one or two or more types of thermoplastic resins selected from polyolefin-based resins, polyester-based resins, polyamide-based resins, polyphenylene sulfide resins, polycarbonate resins, polyether ether ketone resins, polyether ketone resins, polyimide resins, polyether sulfone resins, polystyrene resins, polyacrylonitrile resins, styrene-acrylonitrile copolymer resins, acrylonitrile-butadiene-styrene copolymer resins, (meth)acrylic resins, and polyacetal resins are preferably used from the viewpoint that the effect of improving the bonding strength between the metal plate and the resin member can be more effectively obtained.

As the polyolefin-based resins, polymers obtained by polymerizing an olefin can be used without particular limitation.

Examples of the olefin constituting the polyolefin-based resin include ethylene, an α-olefin, a cyclic olefin, and a polar olefin.

Examples of the α-olefin include a linear or branched α-olefin having 3 to 30 carbon atoms, preferably 3 to 20 carbon atoms. More specific examples thereof include propylene, 1-butene, 1-pentene, 3-methyl-1-butene, 1-hexene, 4-methyl-1-pentene, 3-methyl-1-pentene, 1-octene, 1-decene, 1-dodecene, 1-tetradecene, 1-hexadecene, 1-octadecene, and 1-eicosene.

Examples of the cyclic olefin include a cyclic olefin having 3 to 30 carbon atoms, preferably 3 to 20 carbon atoms. More specific examples thereof include cyclopentene, cycloheptene, norbornene, 5-methyl-2-norbornene, tetracyclododecene, and 2-methyl-1,4,5,8-dimethano-1,2,3,4,4a,5,8,8a-octahydronaphthalen e.

Examples of the polar olefin include vinyl acetate, methyl methacrylate, methyl acrylate, and ethyl acrylate.

Preferable examples of the olefin constituting the polyolefin-based resin include ethylene, propylene, 1-butene, 1-pentene, 3-methyl-1-butene, 1-hexene, 4-methyl-1-pentene, and 3-methyl-1-pentene. Among these, ethylene, propylene, 1-butene, 1-hexene, 4-methyl-1-pentene are more preferable, and ethylene or propylene is even more preferable.

The polyolefin-based resin may be obtained by polymerizing the above-described olefins alone, or by combining two or more types of the olefins and performing random copolymerization, block copolymerization, or graft copolymerization.

The polyolefin-based resin may be a blend formed of polyolefins having different properties. Examples thereof include a blend body of one or more selected from a propylene homopolymer, a propylene random copolymer, and a propylene block copolymer, and an elastomer such as propylene-ethylene copolymer rubber and an ethylene-α-olefin copolymer (here, the α-olefin is 1-butene, 1-hexene, 1-octene, or the like).

In addition, the polyolefin-based resin may be linear or may have a branched structure introduced therein.

Examples of the polyester-based resins include aliphatic polyesters such as a polylactic acid, a polyglycolic acid, polycaprolactone, and polyethylene succinate, polyethylene terephthalate, polyethylene naphthalate, polybutylene terephthalate (PBT), and polycyclohexylenedimethylene terephthalate (PCT).

Examples of the polyamide-based resins include ring-opening polymerization-based aliphatic polyamides such as PA6 and PA12; polycondensation-based polyamides such as PA66, PA46, PA610, PA612, and PAll; semi-aromatic polyamides such as MXD6, PA6T, PA9T, PA6T/66, PA6T/6, and amorphous PA; wholly aromatic polyamides such as poly(p-phenylene terephthalamide), poly(m-phenylene terephthalamide), and poly(m-phenylene isophthalamide), and amide-based elastomers.

As the thermosetting resin, a phenolic resin, an epoxy resin, an unsaturated polyester resin, a diallyl phthalate resin, a melamine resin, an oxetane resin, a maleimide resin, an urea (urea) resin, a polyurethane resin, a silicone resin, a resin having a benzoxazine ring, a cyanate ester resin, and the like can be used. These may be used alone or in combination of two or more types thereof.

In addition, as the thermosetting resin, a fiber-reinforced thermosetting resin such as SMC or carbon fiber reinforced plastic (CFRP) can also be used.

The resin composition (P) may contain other blending agents (P2) for the purpose of imparting individual functions. Examples of the blending agents (P2) include a filler, a flame retardant, a flame retardant aid, a heat stabilizer, an antioxidant, a pigment, a weathering agent, a plasticizer, a dispersant, a lubricant, a release agent, an antistatic agent, and an impact resistance modifier.

In this embodiment, the resin member preferably further contains a filler from the viewpoint of adjusting a difference in coefficient of linear expansion between the metal plate and the resin member and improving the mechanical strength of the resin member.

As the filler, for example, one or two or more can be selected from the group consisting of hydrotalcites, glass fibers, carbon fibers, metal fibers, organic fibers, carbon particles, clay, talc, silica, minerals, and cellulose fibers. Among these, one or two or more selected from hydrotalcites, glass fibers, carbon fibers, talc, and minerals are preferable. A heat dissipating filler typified by alumina, forsterite, mica, alumina nitride, boron nitride, zinc oxide, magnesium oxide, or the like can also be used.

The shape of the filler is not particularly limited, and may be any shape such as a fibrous shape, a particle shape, or a plate shape.

In a case where the resin member contains a filler, the content thereof is, for example, 5 mass% or more and 95 mass% or less, preferably 10 mass% or more and 90 mass% or less, and more preferably 20 mass% or more and 90 mass% or less when the entire resin member is 100 mass%.

The filler has an effect of increasing the rigidity of the resin member and an effect of controlling the coefficient of linear expansion of the resin member. In particular, in the cooling type housing 100 of this embodiment, the metal plate and the resin member are often significantly different in temperature dependence of the shape stability, and thus the cooling type housing 100 is easily distorted in a case where a large temperature change occurs. In a case where the resin member contains a filler, the distortion can be reduced. In addition, in a case where the content of the filler is in the above range, it is possible to suppress a reduction in toughness.

In this embodiment, the filler is preferably a fibrous filler, more preferably glass fibers and carbon fibers, and particularly preferably glass fibers.

Accordingly, since it is possible to suppress the shrinkage of the resin member after molding, the bonding between the metal plate and the resin member can be further strengthened.

The hydrotalcites include natural products and synthetic products, and examples thereof include hydrotalcites not containing hydrous basic carbonate such as magnesium, calcium, zinc, aluminum, and bismuth or crystal water thereof. Examples of the natural products include those having a structure of Mg₆Al₂(OH)₁₆CO₃·₄H₂O. Examples of the synthetic products include Mg_{0.7}Al_{0.3}(OH)₂(CO₃)_{0.15}·0.54H₂O, Mg_{4.5}Al₂(OH)₁₃CO₃·3.5H₂O, Mg_{4.2}Al₂(OH)_{12.4}(CO₃)_{0.15}, Zn₆Al₂(OH)₁₆CO₃·4H₂O, Ca₆Al₂(OH)₁₆CO₃·4H₂O, and Mg₁₄Bi₂(OH)_{29.6}·4.2H₂O. The blending amount of the hydrotalcites is preferably 0.01 parts by mass or more and 2 parts by mass or less per 100 parts by mass of the resin composition (P). In a case where the blending amount of the hydrotalcites is equal to or more than the lower limit, the heat resistance of the resin member to be obtained can be improved. In a case where the blending amount of the hydrotalcites is equal to or less than the upper limit, the flame retardancy of the resin member to be obtained can be improved.

Examples of the flame retardant include bis(2,3-dibromopropyl) ether of tetrabromobisphenol A, bis(2,3-dibromopropyl) ether of tetrabromobisphenol S, bis(2,3-dibromopropyl) ether of tetrabromobisphenol A, tris(2,3-dibromopropyl) isocyanurate, and mixtures of two or more type of the above. The content of the flame retardant is, for example, 5 to 25 parts by mass, and preferably 10 to 20 parts by mass per 100 parts by mass of the resin composition (P). In a case where the content of the flame retardant is equal to or more than the lower limit, the flame retardancy of the resin member to be obtained can be improved. In a case where the content of the flame retardant is equal to or less than the upper limit, the mechanical characteristics of the resin member to be obtained can be improved.

The resin composition (P) may contain a flame retardant aid. In a case where the resin composition (P) contains a flame retardant aid, the content thereof is 0.5 to 20 parts by mass, and preferably 1 to 10 parts by mass per 100 parts by mass of the resin composition (P). In a case where the content of the flame retardant aid is equal to or more than the lower limit, it is possible to obtain a sufficient synergistic effect with the flame retardant. In a case where the content of the flame retardant aid is equal to or less than the upper limit, the mechanical characteristics of the resin member to be obtained can be improved. Examples of the flame retardant aid include antimony trioxide (Sb₂O₃) and antimony pentoxide (Sb₂O₅).

The resin composition (P) preferably has high fluidity in order to facilitate the entering into the fine uneven structure applied to the surface of the metal plate. Therefore, in this embodiment, the MFR of the resin composition (P), measured under conditions of a load of 2.16 kg at 230°C according to ASTM D1238, is preferably 1 to 200 g/10 min, and more preferably 5 to 50 g/10 min.

### (Method of Manufacturing Resin Composition (P))

The method of manufacturing the resin composition (P) is not particularly limited, and the resin composition can be manufactured by a generally known method. Examples thereof include the following method. First, the resin (P1) and the optional other blending agents (P2) are mixed or melt-mixed using a mixing device such as a Banbury mixer, a single screw extruder, a twin screw extruder, or a high-speed twin screw extruder to obtain the resin composition (P).

### (Method of Manufacturing Assembled Metal Housing)

Next, a method of manufacturing the assembled metal housing 10 according to this embodiment will be described.

The assembled metal housing 10 according to this embodiment can be formed by, for example, assembling a plurality of metal plates or a development view-like metal plate 20 (hereinafter, also simply referred to as the metal plate).

Hereinafter, a method of manufacturing the metal housing 10 using the development view-like metal plate 20 will be described.

The method of manufacturing the metal housing 10 according to this embodiment includes, for example, the following steps (A) and (C), and optionally includes a step (B) and/or a step (D).
(A) A step of preparing a development view-like metal plate 20 including a metal bottom plate 201 and/or a metal lid plate 203, and a metal side plate 202 (at least one metal plate selected from a side plate 202-1, a side plate 202-2, a side plate 202-3, and a side plate 202-4) which is integrally folded and connected to the bottom plate and/or the lid plate, and optionally having a fine uneven structure at least on a surface of a bonding portion to which a resin member is bonded
(B) A step of bonding the resin member to a surface of the development view-like metal plate 20 by installing the development view-like metal plate 20 in a mold and injecting the resin composition (P) into the mold
(C) A step of forming the development view-like metal plate 20 into a box shape by folding a boundary portion between the bottom plate 201 and/or the lid plate 203 of the development view-like metal plate 20 and the side plate 202
(D) A step of bonding the resin member to a surface of the development view-like metal plate 20 assembled into a box shape, and/or sealing a gap between adjacent sides of the metal plates by installing the development view-like metal plate 20 assembled into a box shape in a mold and injecting the resin composition (P) into the mold

In the method of manufacturing the assembled metal housing 10 according to this embodiment, since the development view-like metal plate 20 which is an intermediate product before folding has a flat plate shape, there is an advantage in that the storage efficiency and the transportation efficiency of large amounts of the intermediate product are improved.

### (Step (A))

First, a development view-like metal plate 20 including a metal bottom plate 201 and/or a metal lid plate 203, and a metal side plate 202 (at least one metal plate selected from a side plate 202-1, a side plate 202-2, a side plate 202-3, and a side plate 202-4) which is integrally folded and connected to the bottom plate and/or the lid plate, optionally having a fine uneven structure at least on a surface of a bonding portion to which the resin member is bonded, and having a shape of a development view of the metal housing 10 is prepared. Here, the development view-like metal plate 20 may be a part (for example, two or more surfaces) of the development view of the metal housing 10.

Here, the development view-like metal plate 20 can be obtained by, for example, subjecting a metal member having a plate shape to processing into a development view shape shown in Fig. 3 by punching or the like, and optionally performing the above-described roughening treatment at least on the surface of the bonding portion to which the resin member is bonded.

Details of the metal member and the roughening treatment will not be repeated here.

### (Step (B))

Next, the resin member is bonded to a surface of the development view-like metal plate 20 by installing the development view-like metal plate 20 in a mold and injecting the resin composition (P) into the mold.

Examples of the method of bonding the resin member include an injection molding method, a transfer molding method, a compression molding method, a reaction injection molding method, a blow molding method, a thermoforming method, and a press molding method. In a case where the resin member is formed of a thermoplastic resin composition, an injection molding method is preferable among the above methods. That is, the resin member is preferably an injection molded product. In a case where the resin member is formed of a thermosetting resin composition, a transfer molding method, a compression molding method, a reaction injection molding method, and a press molding method are preferable. Hereinafter, an example using the injection molding method will be described.

The method of bonding the resin member to the development view-like metal plate 20 using the injection molding method includes, for example, the following steps (i) and (ii).
(i) A step of disposing the development view-like metal plate 20 in an injection molding mold
(ii) A step of injection-molding the resin composition (P) into the mold and molding the resin member so that at least a part of the resin member is in contact with the development view-like metal plate 20

Hereinafter, specific description thereof will be given.

First, (i) an injection molding mold is prepared and opened, and the development view-like metal plate 20 is disposed in a cavity portion (space portion) of the mold. (ii)Then, the mold is closed, the resin composition (P) is injected into the cavity portion of the mold and solidified so that at least a part of the resin member is in contact with the development view-like metal plate 20, and the development view-like metal plate 20 and the resin member are bonded. Then, the mold is opened and released, and thus it is possible to obtain the development view-like metal plate 20 to which the resin member is bonded. As the mold, for example, an injection molding mold which is generally used in injection molding can be used.

Here, in the step (ii), during the period from the start of injection of the resin composition (P) to the end of pressurization, the surface temperature of the mold is preferably maintained at a temperature which is equal to or higher than a glass transition temperature (hereinafter, also referred to as Tg) of the resin member, and more preferably at a temperature of Tg + (5 or more and 150 or less)°C or higher.

Accordingly, it is possible to bring the resin composition (P) into contact with the surface of the development view-like metal plate 20 at a high pressure for a longer time while maintaining the resin composition (P) in a softened state.

As a result, since it is possible to improve the adhesion between the development view-like metal plate 20 and the resin member, it is possible to more stably obtain a metal housing 10 having more excellent bonding strength.

As the injection molding method, high-speed heat cycle molding (RHCM, heat & cool molding) may be used, and in this case, as a method of heating the mold, any one of a steam type, a pressurized hot water type, a hot water type, a hot oil type, an electric heater type, and an electromagnetic induction superheat type, or a combination thereof may be used.

In the step (ii), the time from the start of injection to the end of pressurization is preferably 1 second or longer and 60 seconds or shorter, and more preferably 3 seconds or longer and 30 seconds or shorter.

In a case where the time is equal to or longer than the lower limit, it is possible to bring the resin member into contact with the fine uneven structure of the development view-like metal plate 20 at a high pressure for a longer time while maintaining the resin member in a melted state. Accordingly, it is possible to more stably obtain a metal housing 10 having more excellent bonding strength.

In addition, in a case where the time is equal to or shorter than the upper limit, the molding cycle of the metal housing 10 can be shortened, and thus the metal housing 10 can be more efficiently obtained.

In the method of manufacturing the metal housing 10 according to this embodiment, in the step (B), the resin composition (P) is preferably injected into the mold so that the resin member is not bonded to the boundary portion between the bottom plate 201 and/or the lid plate 203 and the side plate 202. Therefore, it is possible to obtain a development view-like metal plate 20 in which the resin member is not bonded to the boundary portion between the bottom plate 201 and/or the lid plate 203 and the side plate 202, and as a result, it becomes easier to fold the boundary portion between the bottom plate 201 and the side plate 202, and it becomes easier to form the development view-like metal plate 20 into a box shape. Therefore, the productivity of the metal housing 10 can be further improved.

### (Step (C))

Next, the development view-like metal plate 20 is formed into a box shape by folding the boundary portion between the bottom plate 201 and/or the lid plate 203 and the side plate 202, and thus the metal housing 10 is obtained.

The method of forming the development view-like metal plate 20 into a box shape is not particularly limited, and a generally known method can be used. For example, the metal housing 10 is obtained by folding the boundary portion between the bottom plate 201 and/or the lid plate 203 and the side plate 202.

In this case, the adjacent side plates 202, and the bottom plate 201 and/or the lid plate 203 connected to the side plate 202 may be engaged by a mechanical method. The mechanical engagement method is not particularly limited, and examples thereof include screwing.

### (Step (D))

Next, the resin member is bonded to the surface of the development view-like metal plate 20 assembled into a box shape, and/or a gap between adjacent sides of the metal plates is sealed by installing the development view-like metal plate 20 assembled into a box shape in a mold and injecting the resin composition (P) into the mold.

As a method of bonding the resin member to the surface of the development view-like metal plate 20 assembled into a box shape and a method of sealing the gap between adjacent sides of the metal plates, for example, the same molding method as described in the step (B) can be employed.

Here, the resin sealing material 40 and the resin member are preferably formed of the same resin. Accordingly, it becomes easy to simultaneously perform the bonding of the resin member and the resin sealing with the resin sealing material 40, and the productivity can be improved.

### <Cooling Flow Path>

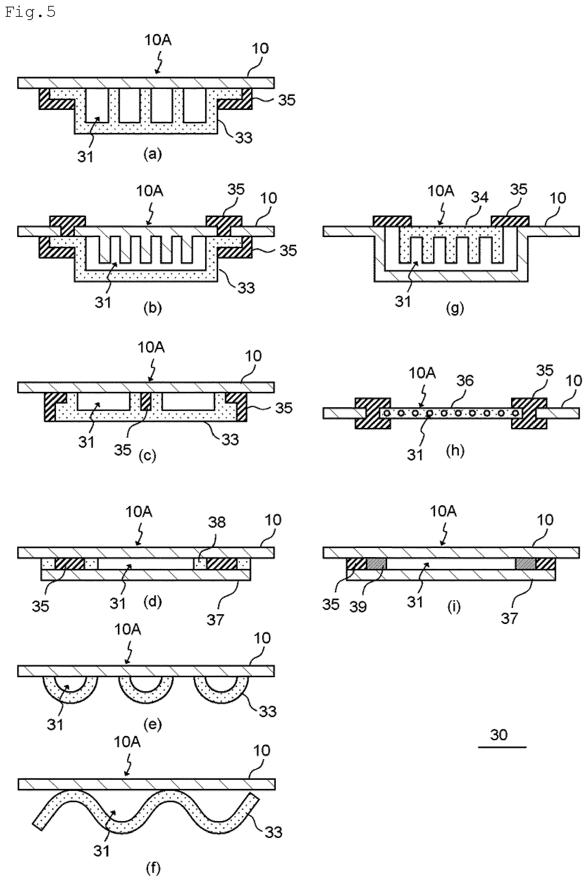

Fig. 5 shows cross-sectional views schematically showing an example of the structure of the cooling flow path 30 according to this embodiment.

The cooling flow path 30 according to this embodiment is not particularly limited as long as it has a structure in which the heat medium flowing through the space portion 31 is in contact with the one surface 10A of the metal housing 10, and examples thereof include structures each formed of a plurality of members including the metal housing 10 as in Figs. 5(a) to 5(i).

In addition, in the cooling flow path 30 according to this embodiment, for example, the plurality of members are bonded by a resin bonding member 35.

In Figs. 5(a) to 5(c), the cooling flow path 30 has a structure in which a resin flow path 33 is in contact with the one surface 10A of the metal housing 10, and the resin flow path 33 and the metal housing 10 are bonded by the resin bonding member 35. In this case, the space portion 31 between the one surface 10A of the metal housing 10 and the resin flow path 33 serves as a flow path. Here, the resin flow path 33 may be a metal flow path. In that case, a surface of the metal flow path preferably has the above-described fine uneven structure. Accordingly, the metal flow path and the resin bonding member 35 can be bonded.

In Fig. 5(d), the cooling flow path 30 has a structure in which a metal plate 37 to which a resin member 38 as a bank of the flow path is applied is in contact with the one surface 10A of the metal housing 10, and the metal plate 37 and the metal housing 10 are bonded by the resin bonding member 35. In this case, the space portion 31 between the one surface 10A of the metal housing 10 and the metal plate 37 serves as a flow path.

In Figs. 5 (e) and 5(f), the cooling flow path 30 has a structure in which the resin flow path 33 is directly bonded to the one surface 10A of the metal housing 10. In this case, the space portion 31 between the one surface 10A of the metal housing 10 and the resin flow path 33 serves as a flow path.

In Fig. 5(g), the cooling flow path 30 has a structure in which a part of the metal housing 10 has a recessed shape, and a metal flow path 34 is fixed to the recessed portion by the resin bonding member 35. In this case, the space portion 31 between the metal housing 10 and the metal flow path 34 serves as a flow path.

In Fig. 5(h), the cooling flow path 30 has a structure in which a part of the metal housing 10 is an opening portion, and a perforated plate 36 is fixed to the opening portion by the resin bonding member 35. In this case, a hole of the perforated plate 36 serves as a flow path.

In Fig. 5(i), the cooling flow path 30 has a structure in which a metal plate 37 to which an elastomer 39 as a bank of the flow path is applied is in contact with the one surface 10A of the metal housing 10, and the metal plate 37 and the metal housing 10 are bonded by the resin bonding member 35. In this case, the space portion 31 between the one surface 10A of the metal housing 10 and the metal plate 37 serves as a flow path.

The cooling flow path 30 exchanges heat with the metal plate constituting any surface of the metal housing 10, such as the metal plate constituting the bottom plate 201. For example, in a case where the temperature of the metal housing 10 is increased by the heat generated from the heating element 50, the heat of the metal housing 10 is transferred to the cooling flow path 30, and as a result, the metal housing 10 is cooled. In a case where the temperature of the metal housing 10 is lower than necessary, the heat of the cooling flow path 30 is transferred to the metal housing 10, and as a result, the metal housing 10 is heated.

The surface on which the cooling flow path 30 is provided in the cooling type housing 100 is, for example, the bottom plate 201 of the metal housing 10. However, it may be any side plate 202 or the lid plate 203. In addition, the cooling flow path 30 may be provided on a plurality of surfaces of the metal housing 10.

The fluid flowing inside the cooling flow path 30 is not particularly limited, and is, for example, a liquid such as water or oil.

Hereinafter, the cooling flow path 30 will be described with reference to the structure of Fig. 5(a).

As shown in Fig. 5(a), the cooling flow path 30 according to this embodiment includes, for example, the resin flow path 33 in which the space portion 31 serving as a flow path is provided on at least one surface, the one surface 10A of the metal housing 10 for cooling the heating element 50, which covers the space portion 31 and of which at least a part is in contact with the resin flow path 33, and the resin bonding member 35 for bonding the resin flow path 33 and the metal housing 10.

A side wall portion of the resin flow path 33 is usually provided with a heat medium injection port and a heat medium recovery port, which are liquid passing ports for inflow and outflow of the heat medium.

In addition, since the resin flow path 33 is integrally formed of a lightweight resin material, the weight of the entire cooling type housing 100 can be reduced.

In addition, it is preferable that the metal housing 10 has a fine uneven structure at least on a surface of a bonding portion with the resin bonding member 35, and the metal housing 10 and the resin bonding member 35 are bonded by allowing a part of the resin bonding member 35 to enter into the fine uneven structure.

The bondability between the metal housing 10 and the resin bonding member 35 can be increased by allowing a part of the resin bonding member 35 to enter into the fine uneven structure of the metal housing 10. Accordingly, the resin flow path 33 and the metal housing 10 can be firmly bonded by using the resin bonding member 35, and thus the airtightness between the resin flow path 33 and the metal housing 10 can be further increased. Accordingly, the risk of leakage of the heat medium from the cooling type housing 100 can be suppressed.

Here, from the viewpoint of further reducing the risk of leakage of the heat medium from the cooling flow path 30, it is preferable that the resin component constituting the resin flow path 33 and the resin component constituting the resin bonding member 35 are integrated at least at the bonding portion between the resin flow path 33 and the resin bonding member 35, and it is more preferable that the resin component constituting the resin flow path 33 and the resin component constituting the resin bonding member 35 are fused at least at the bonding portion between the resin flow path 33 and the resin bonding member 35. Accordingly, the bondability between the resin flow path 33 and the resin bonding member 35 is improved, and the leakage of the heat medium from the bonding portion between the resin flow path 33 and the resin bonding member 35 can be further suppressed. In a case where the resin flow path 33 and the resin bonding member 35 have appearances of the same color, it may be difficult to visually determine that the resin flow path and the resin bonding member are integrated. As a method of observing the integration between the resin components, for example, by cutting a portion where the resin components are integrated and observing a cross-section of the cut portion with an optical microscope or a polarizing microscope, a boundary portion where the orientation state of the resin crystal orientation layer or the reinforcing filler orientation layer during the molding of the resin changes can be determined as the portion where the resin components are integrated.

In the cooling flow path 30 according to this embodiment, it is preferable that both the resin component constituting the resin flow path 33 and the resin component constituting the resin bonding member 35 are thermoplastic resins or thermosetting resins, and it is more preferable that the resin component constituting the resin flow path 33 and the resin component constituting the resin bonding member 35 include resins of the same series. Accordingly, the compatibility between the resin component constituting the resin flow path 33 and the resin component constituting the resin bonding member 35 can be improved, and as a result, the bondability between the resin flow path 33 and the resin bonding member 35 can be improved.

In addition, even in a case where the resin component constituting the resin flow path 33 and the resin component constituting the resin bonding member 35 are resins of different series, high compatibility can be obtained by selecting different resins having a strong chemical interaction with each other. Furthermore, by previously modifying the surface of the resin flow path 33 by a surface treatment or the like or imparting a functional group, the bondability with the resin bonding member 35 can be improved. Examples of the modification method for the resin flow path 33 include a plasma treatment, an itro treatment, a flame treatment, a UV treatment, and a corona treatment.

As shown in Fig. 1, in the cooling flow path 30 according to this embodiment, the resin flow path 33 and the metal housing 10 are usually in contact with each other at an outer periphery of the resin flow path 33. However, from the viewpoint of further firmly bonding the resin flow path 33 and the metal housing 10 and further increasing the airtightness between the resin flow path 33 and the metal housing 10, the resin flow path 33 and the metal housing 10 are preferably provided to be in close contact with each other at one or more parts even inside the resin flow path 33 (a part other than the outer periphery, for example, a central part).

In the cooling flow path 30 according to this embodiment, it is usually preferable that the resin flow path 33 and the metal housing 10 are not directly bonded, the resin bonding member 35 is bonded to each of the resin flow path 33 and the metal housing 10, and thus the resin flow path 33 and the metal housing 10 are indirectly bonded, that is, in close contact with each other to maintain airtightness so that the heat medium does not leak. Usually, the resin flow path 33 and the metal housing 10 are not directly bonded since the resin flow path 33 having the space portion 31 is formed, and then attached to the metal housing 10. Here, in this embodiment, the state in which the resin flow path 33 and the metal housing 10 are directly bonded means that a part of the resin flow path 33 enters into the fine uneven structure of the surface of the metal housing 10, and the metal housing 10 and the resin flow path 33 are thus bonded. The state does not include a state in which the resin flow path 33 and the metal housing 10 are bonded by a bonding method selected from an adhesive method, a heat fusion method, and a mechanical fastening method.

In the cooling flow path 30 according to this embodiment, the resin flow path 33 may include a plurality of flow path units. Accordingly, the flow of the heat medium can be more complicatedly controlled, and for example, a plurality of heating elements can be simultaneously liquid-cooled.

Here, the plurality of flow path units may be configured to be integrated or divided. In a case where the plurality of flow path units are divided, the flow path units can be connected to each other by using, for example, a pipe through which the heat medium flows.

The number of flow path units constituting the resin flow path 33 is not particularly limited, and can be optionally set according to the size or the number of heating elements to be cooled.

Since the entire metal housing 10 is cooled by a heat medium such as a refrigerant flowing through the flow path formed inside the cooling flow path 30, it is possible to increase the cooling efficiency of the heating element 50 which is in contact with the surface of the metal housing 10 opposite to the contacting surface with the resin flow path 33. In addition, since the resin flow path 33 in which the heat medium flow path is formed is formed of a lightweight material having an excellent heat insulation property, this can contribute to a reduction in weight of the entire structural body, and improve the cooling efficiency.

In the cooling flow path 30 according to this embodiment, it is preferable that the resin flow path 33 and the metal housing 10 are tightly and firmly bonded in order to ensure strict watertightness so that the heat medium does not leak even in a severe use environment. For this, the resin bonding member 35 and another bonding method may be combined. Preferable bonding methods other than the resin bonding member 35 include one or two or more selected from an adhesive method, a heat fusion method, and a mechanical fastening method.

For example, there is a method of bonding the resin flow path 33 and the metal housing 10 by using heat fusion. A method of forming a resin bank portion on the surface of the metal housing 10 by a method such as insert molding, and then bonding the resin flow path onto the resin bank portion by a fusion method is a method using a resin-metal heat fusion method and a resin-resin heat fusion method in combination. For example, a method of bonding the resin flow path 33 and the metal housing 10 via an adhesive is bonding using an adhesive method. A method of bonding the resin flow path 33 and the metal housing 10 via an adhesive, and then mechanically fastening the resin flow path and the metal housing is a bonding method in which a heat fusion method and a mechanical fastening method are combined.

As the adhesive used in the above bonding method, a known natural or synthetic adhesive can be used without limitation, and a synthetic adhesive is preferable from the viewpoint of persistence of the adhesive force.

Synthetic adhesives can be classified into thermoplastic adhesives, heat curable adhesives, and elastomers, and heat curable adhesives are preferable from the viewpoint of adhesion strength. The heat curable adhesive may be a room temperature-reactive adhesive (one component type), a thermosetting adhesive (two component type), or a light curable adhesive.

The type of the adhesive is optionally determined by those skilled in the art depending on the circumstances such as what kind of characteristics is to be imparted to the cooling device and what kind of material is to be used for forming the cooling device.

In the cooling flow path 30 according to this embodiment, examples of the mechanical fastening between the resin flow path 33 and the metal housing 10 include mechanical fastening by rivets, screws, or the like. In this case, at least an outer peripheral end portion of the metal housing 10 and the resin flow path 33 are preferably riveted or screwed. Riveting or screwing can also be performed not only at the outer peripheral end portion of the one surface 10A of the metal housing 10 but also around a central portion of the one surface 10A of the metal housing 10 to the extent that the flow of the flow path is not obstructed. In a case where the outer peripheral end portion of the one surface 10A of the metal housing 10 is mechanically bonded and the one surface 10A of the metal housing 10 has, for example, a rectangular shape when seen in a plan view, at least four corners of the outer peripheral portion are preferably mechanically bonded. The metal housing 10 and the resin flow path 33 may be mechanically bonded after a resin base for mechanical bonding is formed not only at the outer peripheral end portion of the one surface 10A of the metal housing 10 but also around the central portion of the one surface 10A of the metal housing 10. In this case, by positioning the resin base portion in the flow path so that the flow path causes turbulence, it may be possible to contribute to equalization of the temperature of the heat medium passing through the flow path.

In addition, in the cooling flow path 30 according to this embodiment, the resin flow path 33 and the metal housing 10 are preferably mechanically bonded by rivets, screws, or the like in addition to being bonded (adhesive method) via an adhesive layer as described above. As described above, in a case where the resin flow path 33 and the metal housing 10 are firmly bonded in two stages, it is possible to more effectively suppress the leakage of the heat medium flowing in the resin flow path 33.

In this embodiment, the average thickness of adhesive layers for a case where the bonding is performed using the adhesive method is, for example, 0.5 to 5,000 µm, preferably 1.0 to 2,000 µm, and more preferably 10 to 1,000 µm. In a case where the average thickness is equal to or more than the lower limit, the adhesion strength between the resin flow path 33 and the metal housing 10 can be improved, and in a case where the average thickness is equal to or less than the upper limit, the residual strain amount generated during the curing reaction can be suppressed.

In the cooling flow path 30 according to this embodiment, a primer layer may be provided between the resin flow path 33 and the adhesive layer and between the adhesive layer and the metal housing 10. The primer layer is not particularly limited, and is usually made of a resin material containing a resin component constituting the resin layer. The resin material for a primer layer is not particularly limited, and a known material can be used. Specific examples thereof include polyolefin-based primers, epoxy-based primers, and urethane-based primers. The primers may be used in combination of two or more types thereof, including a multilayer mode.

The resin flow path 33 and the resin bonding member 35 according to this embodiment each are preferably a molded body of a thermoplastic resin composition. The resin composition contains a thermoplastic resin as a resin component, and may further optionally contain a filler. The thermoplastic resin is not particularly limited, and is the same as the thermoplastic resin of the resin (P1) contained in the resin composition (P).

As the thermoplastic resin, one or two or more types of thermoplastic resins selected from polyolefin-based resins, polyester-based resins, polyamide-based resins, fluororesins, polyarylene ether-based resins, and polyarylene sulfide-based resins are preferably used from the viewpoint that the bonding strength between the resin flow path 33 and the resin bonding member 35 or the adhesion strength between the metal housing 10 and the resin bonding member 35 can be more effectively obtained, or that the resistance to chemicals contained in the heat medium can be effectively exhibited.

Here, as described above, it is more preferable that the resin component constituting the resin flow path 33 and the resin component constituting the resin bonding member 35 include resins of the same series. In this embodiment, the resins of the same series mean resins which may have different molecular weights or different monomer components in the same classification. For example, resins included in the classification of polyolefin-based resins are all resins of the same series even in a case where these have different molecular weights or monomer components.

In the resin composition according to this embodiment, an optional component and a filler can be used in combination from the viewpoint of improving mechanical characteristics of the resin flow path 33 and the resin bonding member 35 and adjusting a difference in coefficient of linear expansion. The filler is the same as that used in the resin composition (P).

The shape of the fillers is not particularly limited, and may be any one of a fibrous shape, a particle shape, a plate shape, and the like. However, in a case where the surface of the metal housing 10 has a fine uneven structure, a filler having a size large enough to enter the recessed portion is preferably used.

In a case where the resin composition contains a filler, the content of the filler is preferably 1 part by mass or more and 100 parts by mass or less, more preferably 5 parts by mass or more and 90 parts by mass or less, and particularly preferably 10 parts by mass or more and 80 parts by mass or less with respect to 100 parts by mass of the thermoplastic resin.

A thermosetting resin composition can also be used as the resin flow path 33 according to this embodiment. The thermosetting resin composition is a resin composition containing a thermosetting resin. The thermosetting resin is not particularly limited, and is the same as the thermoplastic resin of the resin (P1) contained in the resin composition (P).

Among these, a thermosetting resin composition containing one or more selected from the group consisting of a phenolic resin, an epoxy resin, and an unsaturated polyester resin is preferably used from the viewpoint of heat resistance, workability, mechanical characteristics, adhesion, rust resistance, and the like. The content of the thermosetting resin in the thermosetting resin composition is preferably 15 parts by mass or more and 60 parts by mass or less, and more preferably 25 parts by mass or more and 50 parts by mass or less, assuming that a total amount of the resin composition is 100 parts by mass. The residual component is, for example, a filler, and as the filler, for example, the above-described filler can be used.

A known method can be used without limitation as a method of molding the resin flow path 33, and examples thereof include injection molding, extrusion molding, hot press molding, compression molding, transfer molding, cast molding, laser welding molding, reaction injection molding (RIM molding), liquid injection molding (LIM molding), and spray molding. Among these, an injection molding method is preferable as the method of molding the resin flow path 33 from the viewpoint of productivity and quality stability.

The resin flow path 33 according to this embodiment has, for example, a bottom portion and a side wall portion erected on the bottom portion. The shape of the resin flow path 33 is preferably composed of a bottom portion having a rectangular shape when seen in a plan view and four side wall portions erected on the bottom portion and having a rectangular frame shape when seen in a plan view, and a plurality of threshold-like barriers are formed to form a heat medium flow path on the bottom portion. A top surface of the barrier is preferably in contact with the surface of the one surface 10A of the metal housing 10 opposite to the surface on which the heating element 50 is mounted. The top surface and the metal housing 10 may be bonded by an adhesive.

A plurality of space portions 31 are formed in the entire bottom surface of the resin flow path 33 according to this embodiment on the side of the metal housing 10, and the space portions 31 function as a heat medium flow path due to the close contact between the resin flow path 33 and the one surface 10A of the metal housing 10.

Bamboo blind-like or reinforcing ribs are preferably formed in the surface of the resin flow path 33 according to this embodiment, which is opposite to the surface on the side of the one surface 10A of the metal housing 10. Such reinforcing ribs are preferably made of the same material as the resin flow path 33. By providing the reinforcing ribs, the structure of the resin flow path 33 can be protected from external stress. In addition, by setting a rib height of the reinforcing ribs high, a sufficient space can be formed between the resin flow path 33 and the contact plane, and as a result, the heat insulating effect of the resin flow path 33 can be further improved, and it may be possible to extend the duration of the cooling function. Otherwise, by reducing a distance between the reinforcing ribs, the heat insulating effect of the resin flow path 33 can be further improved, and as a result, it may be possible to extend the duration of the cooling function.

The cooling type housing 100 according to this embodiment can be produced by, for example, superposing the surface of the resin flow path 33 where the flow path is formed and the peripheral edge portion of the one surface 10A of the metal housing 10, and then performing injection molding of the resin bonding member 35. In addition, the cooling flow path 30 according to this embodiment can be molded by, for example, die slide injection molding, two-color molding, or the like. In this case, by using a mold for die slide injection molding, a mold for two-color molding, or the like, it is possible to manufacture the cooling type housing 100 according to this embodiment without removing the constituent components such as the resin flow path 33 from the mold for molding.

In addition, it is also possible to manufacture the cooling type housing 100 according to this embodiment by bonding the cooling flow path 30 to the metal plate (including the development view-like metal plate 20) before assembling of the metal housing 10, and by then assembling the development view-like metal plate 20 or plurality of metal plates into a box shape.

### 2. Structural Body

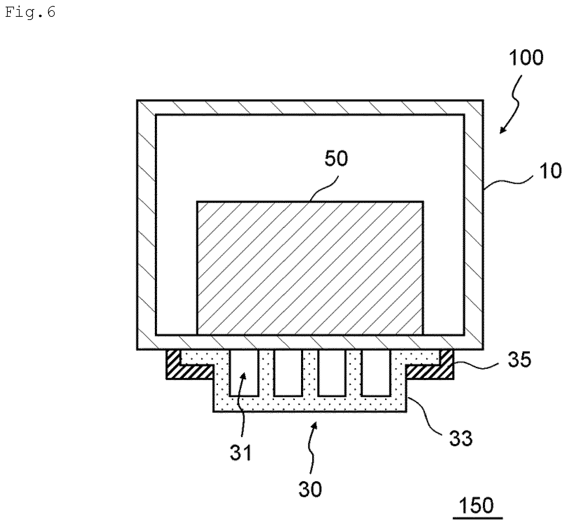

Fig. 6 is a cross-sectional view schematically showing an example of the structure of a structural body 150 according to this embodiment.

The structural body 150 according to this embodiment includes the cooling type housing 100 according to this embodiment and the heating element 50 housed inside the cooling type housing 100. The heating element 50 is disposed on the surface of the cooling flow path 30 in the cooling type housing 100.

The heating element 50 is, for example, a battery such as a secondary battery module or an electronic component such as a power conversion device.

The cooling type housing 100 according to this embodiment can be used as, for example, a housing of a battery module, a battery pack; a power conversion device such as an inverter or a DC-DC converter, or a power control unit provided by combining the devices; a motor; a mechanically and electrically integrated motor (eAxle); a housing for on-vehicle devices such as an engine control unit, an electronic control unit, a charger, and a sensor; an energy storage system (ESS); a server; a supercomputer; or the like.

### <Second Embodiment>

### 1. Cooling Type Housing

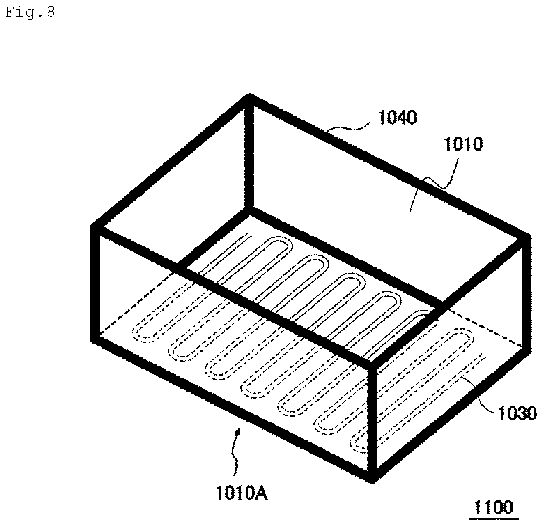

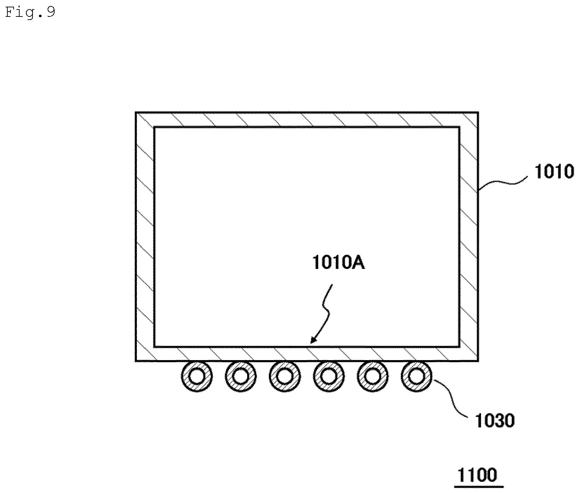

Fig. 8 is a perspective view schematically showing an example of the structure of a cooling type housing 1100 according to this embodiment. Fig. 9 is a cross-sectional view schematically showing an example of the structure of the cooling type housing 1100 according to this embodiment.

The cooling type housing 1100 according to this embodiment is a cooling type housing 1100 for housing a heating element 1050 inside, and includes an assembled metal housing 1010, a heat exchange member 1030 provided at least on one surface 1010A of the metal housing 1010, and a resin sealing material 1040 for sealing a gap between adjacent sides of metal plates constituting the metal housing 1010.

As shown in Fig. 8, the cooling type housing 1100 according to this embodiment includes a resin sealing material 1040 for sealing a gap between metal plates constituting the metal housing 1010. Accordingly, the airtightness inside the cooling type housing 1100 can be increased, and as a result, the cooling type housing can be preferably used for heating elements which are sensitive to moisture, such as secondary battery modules and power conversion devices (inverters, converters, and the like).

The resin composition constituting the resin sealing material 1040 will be described in the section of resin member to be described later.

The tensile elastic modulus of the resin sealing material 1040 at 23°C, measured according to ISO527, is preferably 1,000 MPa or more from the viewpoint of increasing the box rigidity of the metal housing 1010. The upper limit of the tensile elastic modulus of the resin sealing material 1040 at 23°C is not particularly limited, and is, for example, 500 GPa or less.

In the cooling type housing 1100 according to this embodiment, since the one surface 1010A of the metal housing 1010 is cooled by a heat medium (for example, cooling medium) flowing inside the heat exchange member 1030, the cooling efficiency of the heating element 1050 which is disposed inside the metal housing 1010 can be increased.

Therefore, according to this embodiment, it is possible to provide a cooling type housing 1100 having excellent cooling efficiency.

### <Assembled Metal Housing>

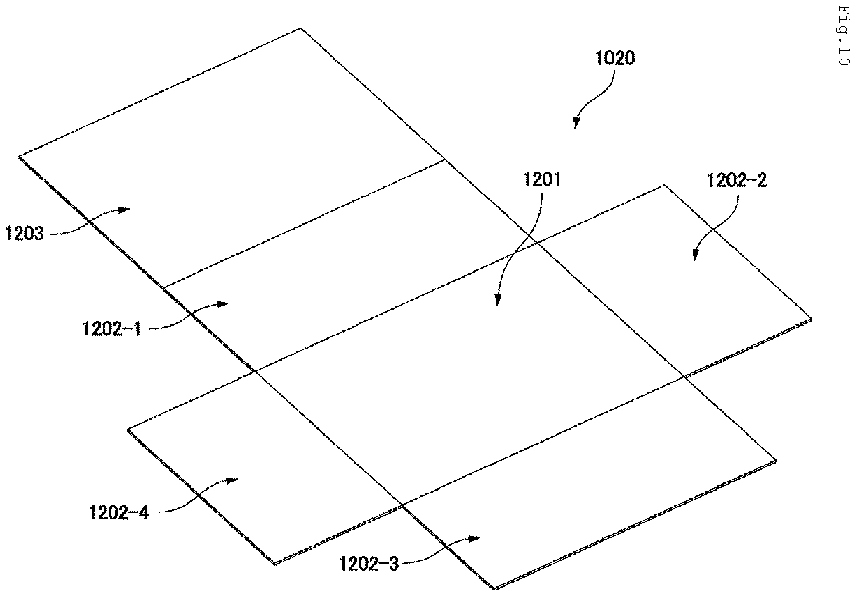

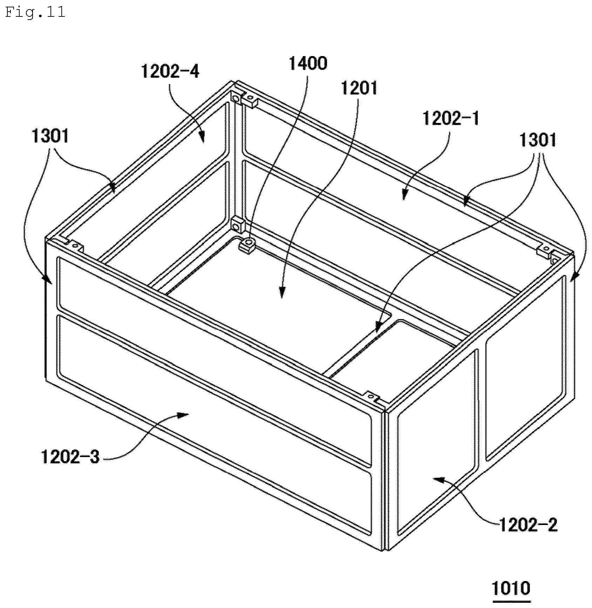

Fig. 10 is a perspective view schematically showing an example of the structure of a development view-like metal plate 1020 according to this embodiment. Fig. 11 is a perspective view schematically showing an example of the structure of the assembled metal housing 1010 according to this embodiment.

The assembled metal housing 1010 according to this embodiment can be formed by, for example, assembling a plurality of metal plates or the development view-like metal plate 1020 (hereinafter, these will also be collectively referred to as the metal plate).

That is, the cooling type housing 1100 can be obtained by, for example, a manufacturing method including a step of preparing a plurality of metal plates or a development view-like metal plate 1020, a step of assembling the plurality of metal plates or the development view-like metal plate 1020 to produce the metal housing 1010, and a step of sealing a gap between adjacent sides of the metal plates constituting the metal housing 1010 with the resin sealing material 1040.

### (Metal Plate)

The metal plate of this embodiment is the same as the metal plate of the first embodiment. That is, as for the metal housing 1010 of this embodiment, a plurality of metal plates or the development view-like metal plate 1020 can be assembled in the same manner as in the first embodiment. Therefore, since the development view-like metal plate 1020 of this embodiment is the same as the development view-like metal plate 1020 of the first embodiment, description thereof will not be repeated. In this embodiment, side plates 1202 may be engaged with each other only by the resin sealing material 1040, or may be engaged by the mechanical method described in the first embodiment.

### (Surface Treatment)

The surface treatment method of this embodiment is the same as the surface treatment method of the first embodiment, and description thereof will not be repeated.

### (Resin Member)

As in the first embodiment, in the metal housing 1010 of this embodiment, a resin member may be further bonded to one surface of the metal housing 1010. The resin member of the embodiment is the same as the resin member of the first embodiment, and description thereof will not be repeated.

### (Method of Manufacturing Resin Composition (P))

The method of manufacturing a resin composition (P) of this embodiment is the same as the method of manufacturing the resin composition (P) of the first embodiment, and description thereof will not be repeated.

### (Method of Manufacturing Assembled Metal Housing)

Next, a method of manufacturing the assembled metal housing 1010 according to this embodiment will be described.

The assembled metal housing 1010 according to this embodiment can be formed by, for example, assembling a plurality of metal plates or a development view-like metal plate 1020 (hereinafter, also simply referred to as the metal plate).

Hereinafter, a method of manufacturing the metal housing 1010 using the development view-like metal plate 1020 will be described.

The method of manufacturing the metal housing 1010 according to this embodiment includes, for example, the following steps (A), (C), and (D), and optionally includes a step (B) and/or a step (E) . Here, the step (D) and the step (E) may be simultaneously performed.
(A) A step of preparing a development view-like metal plate 1020 including a metal bottom plate 1201 and/or a metal lid plate 1203, and a metal side plate 1202 (at least one metal plate selected from a side plate 1202-1, a side plate 1202-2, a side plate 1202-3, and a side plate 1202-4) which is integrally folded and connected to the bottom plate and/or the lid plate, and optionally having a fine uneven structure at least on a surface of a bonding portion to which a resin member is bonded
(B) A step of bonding the resin member to a surface of the development view-like metal plate 1020 by installing the development view-like metal plate 1020 in a mold and injecting the resin composition (P) into the mold
(C) A step of forming the development view-like metal plate 1020 into a box shape by folding a boundary portion between the bottom plate 1201 and/or the lid plate 1203 of the development view-like metal plate 1020 and the side plate 1202
(D) A step of sealing a gap between adjacent sides of the metal plates by installing the development view-like metal plate 1020 assembled into a box shape in a mold and injecting the resin composition (P) into the mold
(E) A step of bonding the resin member to a surface of the development view-like metal plate 1020 assembled into a box shape by installing the development view-like metal plate 1020 assembled into a box shape in a mold and injecting the resin composition (P) into the mold

In the method of manufacturing the assembled metal housing 1010 according to this embodiment, since the development view-like metal plate 1020 which is an intermediate product before folding has a flat plate shape, there is an advantage in that the storage efficiency and the transportation efficiency of large amounts of the intermediate product are improved.

### (Steps (A) to (C))

In the method of manufacturing the assembled metal housing 1010 of this embodiment, the steps (A) to (C) are the same as the steps (A) to (C) of the first embodiment, and description thereof will not be repeated.

### (Step (D))

Following the steps (A) to (C), a gap between adjacent sides of the metal plates is sealed by installing the development view-like metal plate 1020 assembled into a box shape in a mold and injecting the resin composition (P) into the mold.

As a method of sealing the gap between adjacent sides of the metal plates, for example, the same molding method as described in the step (B) can be employed.

### (Step (E))

In addition, the step (E) of bonding the resin member to a surface of the development view-like metal plate 1020 assembled into a box shape by installing the development view-like metal plate 1020 assembled into a box shape in a mold and injecting the resin composition (P) into the mold may be further performed.

As a method of bonding the resin member to the surface of the development view-like metal plate 1020 assembled into a box shape, for example, the same molding method as described in the step (B) can be employed.

Here, the resin sealing material 1040 and the resin member are preferably formed of the same resin. Accordingly, it becomes easy to simultaneously perform the step (D) and the step (E), and the productivity can be improved.

### <Heat Exchange Member>

As shown in Figs. 8 and 9, the cooling type housing 1100 has the heat exchange member 1030. The heat exchange member 1030 exchanges heat with the metal plate constituting at least one surface 1010A of the metal housing 1010, such as the bottom plate 1201. For example, in a case where the temperature of the metal housing 1010 is increased by the heat generated from the heating element 1050, the heat of the metal housing 1010 is transferred to the heat exchange member 1030, and as a result, the metal housing 1010 is cooled. In a case where the temperature of the metal housing 1010 is lower than necessary, the heat of the heat exchange member 1030 is transferred to the metal housing 1010, and as a result, the metal housing 1010 is heated. A heat conductive member for transferring heat may be present between the heating element 1050 and the metal housing 1010.

The heat conductive member is, for example, a heat conductive adhesive or a heat conductive sheet, and examples thereof include a thermal interface material (TIM) and a gap filler. Furthermore, at least a part of the metal housing 1010 which is in contact with the heat conductive member preferably has a fine uneven structure. Accordingly, the heat conductive member enters and adheres to the fine uneven structure, and even higher heat conduction efficiency can be exhibited.

The heat exchange member 1030 is provided on the outer surface of the metal housing 1010. However, the heat exchange member 1030 may be provided on the inner surface of the metal housing 1010.

The surface of the metal housing 1010 on which the heat exchange member 1030 is provided is, for example, the bottom plate 1201 of the metal housing 1010. However, it may be any side plate 1202 or the lid plate 1203. In addition, the heat exchange member 1030 may be provided on a plurality of surfaces of the metal housing 1010.

At least a part of the heat exchange member 1030 is fixed to the metal plate constituting the metal housing 1010 by, for example, a resin member. Specifically, a part of the resin member covers the heat exchange member 1030. In the covering portion, the resin member is bonded to both the heat exchange member 1030 and the metal plate. Here, as the resin member for fixing at least a part of the heat exchange member 1030 to the metal housing 1010, the same resin member as that bonded to the metal plate described above can be used.

The surface of at least the part bonded to the resin member in the heat exchange member 1030 preferably has the same fine uneven structure as that of the metal plate. Therefore, a part of the resin member enters into the fine uneven structure of the heat exchange member 1030, and the heat exchange member 1030 and the resin member are thus bonded as in the bonding structure between the metal plate and the resin member. Accordingly, the bonding strength between the heat exchange member 1030 and the resin member is improved.

At least a part of the heat exchange member 1030 which does not overlap with the resin member may be fixed to the metal housing 1010 by another method. The fixing method used here is a bonding method using a metal, such as welding or brazing typified by soldering, but a method using a resin functioning as an adhesive may also be used. In a case where the bonding is performed using a resin, the resin preferably contains a filler having higher heat conductivity than the resin. As the filler, for example, at least one selected from the group consisting of aluminum oxide, aluminum nitride, boron nitride, zinc oxide, and magnesium oxide is used.

The heat exchange member 1030 is, for example, a flow path or a pipe through which a fluid as a heat medium flows. The flow path or pipe is preferably formed of a metal member or a resin member. Therefore, it is possible to exhibit strength that can withstand the pressure of the fluid.

As the resin member constituting the heat exchange member 1030, for example, the same resin member as that bonded to the metal plate described above can be used.

The metal member constituting the heat exchange member 1030 is, for example, one or more selected from iron, a ferrous material, stainless steel, aluminum, an aluminum alloy, magnesium, a magnesium alloy, copper, a copper alloy, titanium, a titanium alloy, and the like. The fluid flowing inside the heat exchange member 1030 is not particularly limited as long as it is a liquid for cooling, and is, for example, a liquid such as water or oil.

In this embodiment, the heat exchange member 1030 is disposed on the surface of the metal housing 1010 when the resin member is bonded to the metal housing 1010. For example, in a case where the resin member is formed by injection molding, the heat exchange member 1030 is disposed in a mold for forming the resin member, and then the resin member is injection-molded. Therefore, the heat exchange member 1030 can be fixed to the metal housing 1010 simultaneously with the formation of the resin member.

### 2. Structural Body

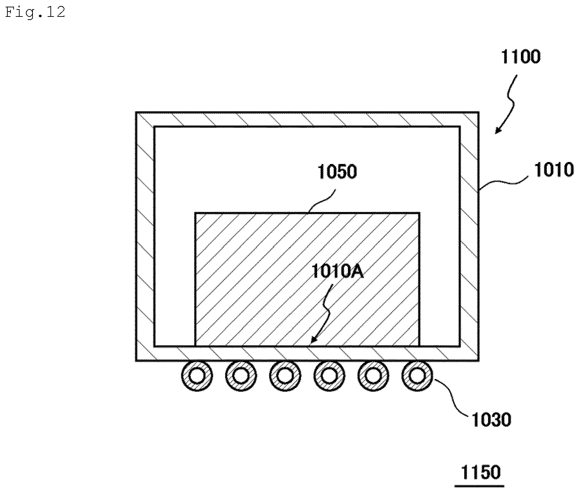

Fig. 12 is a cross-sectional view schematically showing an example of the structure of a structural body 150 according to this embodiment.

The structural body 150 according to this embodiment includes the cooling type housing 1100 according to this embodiment and the heating element 1050 housed inside the cooling type housing 1100.

The heating element 1050 is, for example, a battery such as a secondary battery module or an electronic component such as a power conversion device.

The cooling type housing 1100 according to this embodiment can be used as the same housing as the product described in the first embodiment.

This application claims priority to Japanese Patent Application Nos. 2020-005853 and 2020-005866 filed on January 17, 2020, incorporated herein by reference in its entirety.

### REFERENCE SIGNS LIST

- 10:: metal housing
- 10A:: one surface
- 20:: development view-like metal plate
- 30:: cooling flow path
- 31:: space portion
- 33:: resin flow path
- 34:: metal flow path
- 35:: resin bonding member
- 36:: perforated plate
- 37:: metal plate
- 38:: resin member
- 39:: elastomer
- 40:: resin sealing material
- 50:: heating element
- 100:: cooling type housing
- 104:: bonding portion surface
- 150:: structural body
- 201:: bottom plate
- 202:: side plate
- 202-1:: side plate
- 202-2:: side plate
- 202-3:: side plate
- 202-4:: side plate
- 203:: lid plate
- 301:: reinforcing member
- 400:: boss
- 1010:: metal housing
- 1010A:: one surface
- 1020:: development view-like metal plate
- 1030:: heat exchange member
- 1040:: resin sealing material
- 1050:: heating element (heating source)
- 1100:: cooling type housing
- 1104:: bonding portion surface
- 1150:: structural body
- 1201:: bottom plate
- 1202:: side plate
- 1202-1:: side plate
- 1202-2:: side plate
- 1202-3:: side plate
- 1202-4:: side plate
- 1203:: lid plate
- 1301:: reinforcing member
- 1400:: boss

## Claims

1. A housing for housing a heating source inside, comprising:
an assembled metal housing; and
a heat exchange member provided at least on one surface of the metal housing, in which a heat medium flows,
wherein the heat exchange member constitutes at least a part of the one surface of the metal housing.

2. The housing according to Claim 1,
wherein the heating source and the heat exchange member are in direct contact with each other or in contact with each other through a heat conductive member.

3. The housing according to Claim 1 or 2, further comprising:
a resin sealing material,
wherein a gap between adjacent sides of metal plates constituting the metal housing is sealed with the resin sealing material.

4. The housing according to Claim 3,
wherein tensile elastic modulus of the resin sealing material at 23°C, measured according to ISO527, is 1,000 MPa or more.

5. The housing according to any one of Claims 1 to 4, further comprising:
a resin member bonded to one surface of the metal housing.

6. The housing according to Claim 5,
wherein the resin member includes a reinforcing member.

7. The housing according to Claim 5 or 6,
wherein a metal plate constituting the metal housing has a fine uneven structure at least on a surface of a bonding portion with the resin member, and
the metal housing and the resin member are bonded by allowing a part of the resin member to enter into the fine uneven structure.

8. The housing according to Claim 7,
wherein an interval period of the fine uneven structure is in a range of 0.01 µm or more and 500 µm or less.

9. The housing according to any one of Claims 5 to 8, further comprising:
a resin sealing material,
wherein a gap between adjacent sides of metal plates constituting the metal housing is sealed with the resin sealing material, and
the resin sealing material and the resin member are formed of the same resin.

10. The housing according to any one of Claims 1 to 9,
wherein an average thickness of metal plates constituting the metal housing is 0.2 mm or more and 10 mm or less.

11. The housing according to any one of Claims 1 to 10,
wherein the heat exchange member is formed of a plurality of members including the metal housing, and
the plurality of members are bonded by a resin bonding member.

12. The housing according to Claim 11,
wherein a metal plate constituting the metal housing has a fine uneven structure at least on a surface of a bonding portion with the resin bonding member, and
the metal housing and the resin bonding member are bonded by allowing a part of the resin bonding member to enter into the fine uneven structure.

13. The housing according to Claim 12,
wherein an interval period of the fine uneven structure is in a range of 0.01 µm or more and 500 µm or less.

14. The housing according to any one of Claims 1 to 13,
wherein a metal plate constituting the metal housing is formed of at least one metal member selected from the group consisting of an aluminum member, an aluminum alloy member, a copper member, and a copper alloy member.

15. A housing for housing a heating source inside, comprising:
an assembled metal housing;
a heat exchange member provided at least on one surface of the metal housing; and
a resin sealing material for sealing a gap between adjacent sides of metal plates constituting the metal housing.

16. The housing according to Claim 15,
wherein tensile elastic modulus of the resin sealing material at 23°C, measured according to ISO527, is 1,000 MPa or more.

17. The housing according to Claim 15 or 16, further comprising:
a resin member bonded to one surface of the metal housing.

18. The housing according to Claim 17,
wherein the resin member includes a reinforcing member.

19. The housing according to Claim 17 or 18,
wherein the resin sealing material and the resin member are formed of the same resin.

20. The housing according to any one of Claims 17 to 19,
wherein a metal plate constituting the metal housing has a fine uneven structure at least on a surface of a bonding portion with the resin member, and
the metal housing and the resin member are bonded by allowing a part of the resin member to enter into the fine uneven structure.

21. The housing according to Claim 20,
wherein an interval period of the fine uneven structure is in a range of 0.01 µm or more and 500 µm or less.

22. The housing according to any one of Claims 15 to 21,
wherein an average thickness of metal plates constituting the metal housing is 0.2 mm or more and 10 mm or less.

23. The housing according to any one of Claims 15 to 22,
wherein a metal plate constituting the metal housing is formed of at least one metal member selected from the group consisting of an aluminum member, an aluminum alloy member, a copper member, and a copper alloy member.

24. The housing according to any one of Claims 15 to 23,
wherein a heat medium flows inside the heat exchange member.

25. A structural body comprising:
the housing according to any one of Claims 1 to 24; and
the heating source housed inside the housing,
wherein the heating source is disposed on a surface of the heat exchange member in the housing.

26. The structural body according to Claim 25,
wherein the heating source includes at least one selected from the group consisting of a secondary battery module and a power conversion device.

27. A method of manufacturing the housing according to any one of Claims 1 to 14, comprising:
a step of preparing a plurality of metal plates or a development view-like metal plate; and
a step of producing the metal housing by assembling the plurality of metal plates or the development view-like metal plate.

28. A method of manufacturing the housing according to any one of Claims 15 to 24, comprising:
a step of preparing a plurality of metal plates or a development view-like metal plate;
a step of producing the metal housing by assembling the plurality of metal plates or the development view-like metal plate; and
a step of sealing a gap between adjacent sides of metal plates constituting the metal housing with the resin sealing material.
